Europäisches Patentamt

European Patent Office

Office européen des brevets

(19)

(11) **EP 0 567 701 B1**

(12) # EUROPEAN PATENT SPECIFICATION

(45) Date of publication and mention
of the grant of the patent:
**14.01.1998 Bulletin 1998/03**

(51) Int Cl.⁶: **G01N 21/88**, G01J 9/04

(21) Application number: **92305510.7**

(22) Date of filing: **16.06.1992**

(54) **Inspection method and apparatus**

Verfahren und Gerät zur Inspektion

Méthode et appareil d'inspection

(84) Designated Contracting States:
**AT BE CH DE DK ES FR GB GR IT LI LU NL PT SE**

(30) Priority: **27.04.1992 JP 107678/92**
**28.05.1992 JP 136982/92**

(43) Date of publication of application:
**03.11.1993 Bulletin 1993/44**

(73) Proprietor: **CANON KABUSHIKI KAISHA**
**Tokyo (JP)**

(72) Inventors:
- **Tsuji, Toshihiko, c/o Canon Kabushiki Kaisha**
**Ohta-ku, Tokyo (JP)**
- **Nose, Noriyuki, c/o Canon Kabushiki Kaisha**
**Ohta-ku, Tokyo (JP)**
- **Yoshii, Minoru, c/o Canon Kabushiki Kaisha**
**Ohta-ku, Tokyo (JP)**
- **Miyazaki, Kyoichi, c/o Canon Kabushiki Kaisha**
**Ohta-ku, Tokyo (JP)**
- **Takeuchi, Seiji, c/o Canon Kabushiki Kaisha**
**Ohta-ku, Tokyo (JP)**

(74) Representative:
**Beresford, Keith Denis Lewis et al**
**BERESFORD & Co.**
**2-5 Warwick Court**
**High Holborn**
**London WC1R 5DJ (GB)**

(56) References cited:
**WO-A-88/08519          US-A- 4 353 650**
**US-A- 4 966 457**

- **PATENT ABSTRACTS OF JAPAN vol. 15, no. 91 (P-1175) 20 December 1990; & JP-A-02 307 046**
- **OPTICS LETTERS, vol. 13, no. 5, 1 May 1988, pp. 339-341; R. Dändliker et al.: 'Two-wavelength laser interferometry using superheterodyne detection'**
- **PATENT ABSTRACTS OF JAPAN vol. 15, no. 51 (P-1163) 21 November 1990; & JP-A-02 284 047**
- **PATENT ABSTRACTS OF JAPAN vol. 11, no. 264 (P-610)(2711) 27 August 1987; & JP-A-62 070 738**
- **PATENT ABSTRACTS OF JAPAN vol. 13, no. 162 (P-859)(3510) 19 April 1989; & JP-A-64 000 452**
- **PATENT ABSTRACTS OF JAPAN vol. 14, no. 389 (P-1095)(4332) 22 August 1990; & JP-A-02 147 846**
- **PATENT ABSTRACTS OF JAPAN vol. 13, no. 165 (P-860)(3513) 20 April 1989; & JP-A-01 003 545**

## Description

This invention relates to a method and an apparatus usable, as an example, in the manufacture of microdevices such as semiconductor devices, for inspecting the surface of an article. More particularly, the invention is concerned with a method and an apparatus for optically inspecting the presence/absence of minute particles or defects of the surface of an article. In another aspect, the invention is concerned with a method and an apparatus for manufacturing microdevices such as semiconductor devices by using such an inspection method.

For manufacture of semiconductor devices such as ICs or liquid crystal displays, for example, a circuit pattern formed on an original (called "reticle" or "photomask") is transferred to the surface of a workpiece or wafer having a resist coating by using a semiconductor printing apparatus (called "exposure apparatus"). If in this transfer process there are minute particles (foreign particles) on the surface of the original, also such particles are transferred (printed) on the wafer. This causes decreased yield of IC manufacture. Particularly, in a case where the same circuit pattern is printed on different zones of a wafer sequentially in accordance with the step-and-repeat method, only one particle on the original is printed on every zone of the wafer. This results in a possibility that all the chips produced from this wafer are defective, leading to a substantial decrease in the yield of IC manufacture.

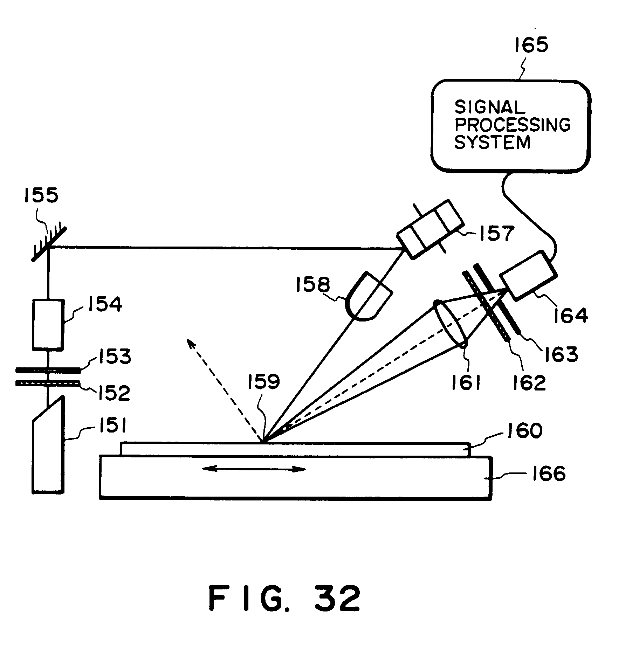

In the IC manufacturing process, it is therefore desired to inspect the presence/absence of minute particles on an original, and many proposals have been made in this respect. Figure 32 shows an example of inspection apparatus. In this example, the presence/absence of any foreign particle is examined by detecting scattered light from the particle.

More particularly, in Figure 32, a laser beam from a laser light source 151 is transformed into a laser beam best suited to inspection, by means of a polarizer 152, a filter 153, a collimating system 154 and so on. Mirror 155 directs the laser beam to a scanning optical system comprising a scanning mirror 157 and an f-θ lens 158. The scanning laser beam from the f-θ lens 158 is converged on the surface 160, to be inspected, of a reticle or the like having a circuit pattern formed thereon, and thus a scanning light spot 159 is formed thereon. Scanning stage system 166 serves to relatively move the scanning spot 159 and the surface 160 in a direction perpendicular to the direction of scan by the scanning spot 159, whereby two-dimensional scan of the whole of the surface 160 is assured.

A detection system comprising a lens system 161, a polarizer 162, an aperture 163 and a photoelectric detector 164 is disposed to receive backward or sideward scattered light. As regards the disposition of this detection system, since there is scattered light from the circuit pattern or the like on the surface 160 which light has a particular direction of diffraction, the detection system has to be disposed off such direction so as not to receive the unwanted diffraction light.

If in this structure there is no particle within the range of the scanning spot 159, no scattered light is detected by the photoelectric detector 164. If there is any particle, it produces scattered light isotropically and, therefore, the photoelectric detector 164 detects any scattered light. Thus, by processing an output signal of the detector in a signal processing system 165, the presence/absence of any foreign particle on the surface can be inspected.

However, this type of inspection apparatus involves such inconveniences as follows:

(1) Where a very small particle of a size of about 0.3 micron or less is to be detected, the produced scattered light has a very low intensity. It is therefore not easy to detect the particle-scattered light with good sensitivity.

(2) There is a case wherein, depending on the circuit pattern used, scattered light goes from the pattern towards the detector. In the detection system like this example which is based only on the intensity information of the scattered light, it is not easy to discriminate the particle-scattered light from the pattern-scattered light. This leads to a decreased signal-to-noise (S/N) ratio.

JP-A-2307046 discloses an inspection apparatus, comprising:

light producing means for producing (i) a first light beam having a first wavelength and (ii) a second light beam having a second wavelength, different from the first wavelength;

light projecting means for projecting at least the first light beam to a position of inspection;

detecting means for detecting heterodyne interference light produced on the basis of the second light beam and the light scattered at said position; and

signal processing means for processing the detected interference light to determine the state at said position of inspection.

In accordance with the present invention, there is provided an inspection apparatus, comprising:

light producing means for producing (i) a first light beam having a first wavelength and (ii) a second light beam having a second wavelength, different from the first wavelength;

light projecting means for projecting at least the first light beam to a position of inspection;

detecting means for detecting heterodyne interference light produced on the basis of the second light beam and the light scattered at said position; and

signal processing means for processing the detected interference light to determine the state at said position of inspection;

characterised in that

said light producing means produces the first light beam having a first state of polarisation and the second light beam having a second state of polarisation different from the first polarisation, and said detecting means is adapted to detect heterodyne interference light produced on the basis of the second light beam and the light scattered at said position and having its state of polarisation changed by the scattering from the first state of polarisation.

Embodiments of the present invention will now be described with reference to the accompanying drawings, in which:

Figure 1 is a schematic view of a first embodiment of the present invention.

Figure 2 is a schematic view for explaining generation of scattered light and detection of a beat signal.

Figure 3 is a schematic view for explaining a beat signal detected.

Figure 4 is a schematic view for explaining the time width of a beat signal detected.

Figure 5 is a diagrammatic view of a beat signal detecting system.

Figure 6 is a schematic view of a detection optical system of this embodiment.

Figure 7 is a schematic view of a modified form of the detection optical system.

Figure 8 is a schematic view of a second embodiment of the present invention.

Figure 9 is a schematic view of a third embodiment of the present invention.

Figures 10A and 10B are graphs each showing the relationship between the relative intensity of scattering and the angle of scattering in particulate size.

Figure 11 is a schematic view of a detection optical system of this embodiment.

Figure 12 is a schematic view of a modified form of the detection system of the third embodiment.

Figure 13 is a schematic view of a fourth embodiment of the present invention.

Figure 14 is a schematic view of a fifth embodiment of the present invention.

Figures 15A, 15B and 15C are graphs each showing the relationship between the relative intensity of scattering and the angle of scattering in a P-polarized component and an S-polarized component.

Figure 16 is a schematic view of a sixth embodiment of the present invention.

Figure 17A is a schematic view of a seventh embodiment of the present invention.

Figure 17B is a schematic view of a modified form of the Figure 17A embodiment.

Figure 18 is a schematic view, showing the relationship between a circuit pattern and a light spot.

Figure 19 is a schematic view, showing the manner of scan of a surface, to be inspected, with a light spot.

Figure 20 is a schematic view, showing an example of the waveform of detection signal which is obtainable with the apparatus of the seventh embodiment.

Figure 21 is a diagrammatic view of a signal processing circuit.

Figure 22 is a schematic view, showing the waveforms of signals at respective portions of the signal processing circuit of Figure 21.

Figure 23 is a schematic view of an eighth embodiment of the present invention.

Figure 24 is a schematic view, showing the waveform of a detection signal obtainable with the apparatus of the eighth embodiment.

Figure 25 is a diagrammatic view of a signal processing circuit.

Figure 26 is a schematic view, showing the waveforms of signals at respective portions of the signal processing circuit of Figure 25.

Figure 27 is a schematic and diagrammatic view of a ninth embodiment of the present invention.

Figure 28 is a schematic and diagrammatic view of an example of the light source system of the ninth embodiment.

Figure 29 is a schematic and diagrammatic view of a tenth embodiment of the present invention.

Figure 30 is a schematic and diagrammatic view of an eleventh embodiment of the present invention, which is applied to a semiconductor device manufacturing system.

Figure 31 is a schematic and diagrammatic view of a twelfth embodiment of the present invention, which is applied to an original cleaning and inspection system.

Figure 32 is a schematic view of a known type inspection apparatus.

Now, description will be made on some preferred embodiments of the present invention which is applied to an apparatus for inspecting a surface of an article such as an original (reticle or photomask) or a workpiece (wafer) used in manufacture of semiconductor devices, more particularly, to an apparatus for inspecting foreign particles such as dust adhered to the surface to be examined or any defects such as scratches on that surface. As a matter of course, the invention is applicable not only to the field of semiconductor device manufacture but also to any other fields wherein the surface inspection is required.

Embodiment 1

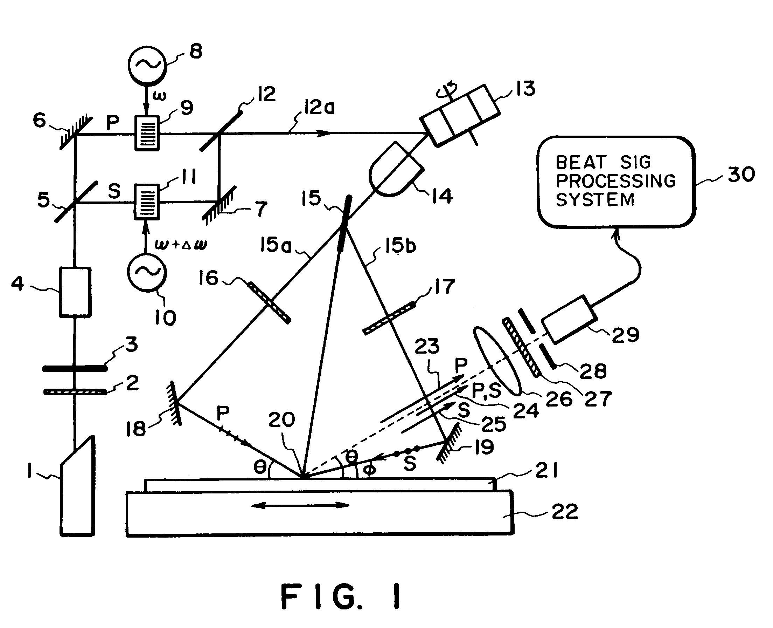

Figure 1 shows a first embodiment of the present invention. Denoted in the drawing at 1 is a laser light source; at 2 is a polarizing plate; at 3 is a filter system; at 4 is a collimator optical system; at 5 and 12 are polarization beam splitters each for separating a laser beam into two mutually orthogonal polarization light components or for combining them; at 6 and 7 are mirrors; at 8 and 9 (10 and 11) are a set of an acousto-optic device and a driver therefor, for modulating the laser beam at a suitable shift frequency; at 13 is a scanning mirror such as a polygonal mirror or a galvano mirror; at 14 is an f-θ lens system; at 15 is a polarization beam splitter having an elongated shape corresponding to the region to be scanned; at 16 and 17 are intensity attenuating filter systems; at 18 and 19 are mirrors; at 20 is a scanning spot; at 21 is the surface of a reticle or the like which is to be inspected; at 22 is a scanning stage system; at 26 is a lens system for directing scattered light from the scanning spot 20 to a photoelectric detector 29; at 27 is a polarization filter; at 28 is a slit-like aperture; at 29 is the aforesaid photoelectric detector; and at 30 is a beat signal processing system.

The laser beam produced by the laser light source 1 is transformed by the polarizing plate 2 and the filter system 3 into a laser beam of suitable intensity having mutually orthogonal linearly polarized light components, which is then collimated by the collimator optical system. This laser beam is them separated by the polarization beam splitter 5 into a P-polarized laser beam and an S-polarized laser beam. Of these laser beams, the P-polarized laser beam is reflected by the mirror 6 and is modulated at a shift frequency ω by the acousto-optic device 9 which is driven by the driver 8. On the other hand, the S-polarized laser beam is modulated at a shift frequency ω+Δω by the acousto-optic device 11 which is driven by the driver 10, and it is reflected by the mirror 7. These two linearly polarized and frequency modulated laser beams are combined by the polarization beam splitter 12, whereby a single laser beam 12a having two mutually orthogonal, linearly polarized light components with a difference attributable to the relative shift frequency difference Δω, is produced.

As regards the arrangement for producing such a laser beam 12a as having the above-described property, it is not limited to the above-descried example. An alternative is that only one acousto-optic device is used to modulate only one of the two laser beams at a shift frequency Δω. As a further alternative, a Zeeman laser light source may be used or an injection current to a semiconductor laser light source may be modulated.

The laser beam 12a is directed to an optical scanning system which comprises the scanning mirror 13 and the f-θ lens system 14, and the laser beam emanating therefrom is separated by the polarization beam splitter 15 into a P-polarized laser beam 15a (shift frequency ω) and an S-polarized laser beam 15b (shift frequency ω+Δω).

The separated laser beam 15a is received by the filter system 16 whereby an intensity suitable to the particle inspection is set. Then, it is converged through cooperation of the mirror 18 upon the surface 21, to be inspected, at an angle of incidence (θ), whereby a spot 20 is formed. On the other hand, the S-polarized laser beam 15b is received by the filter system 17 whereby an intensity suitable to the particle inspection is set. Then, it is converged through cooperation of the mirror 19 at an angle incidence (φ), into a spot 20 on the surface 21. Namely, the laser beams 15a and 15b are converged into the same spot 20 at different incidence angles. The intensity ratio of the laser beams 15a and 15b impinging on the spot 20 may be 1:100, for example. Also, the spot 20 may have a size of about 10 microns. Here, as regards the optical length from the polarization beam splitter 15 to the scanning spot 20, the same length is set to the P-polarized laser beam 15a and the S-polarized laser beam 15b. This assures "interference" even when the spatial coherent length of laser beam is not very long. Also, while the photoelectric detector 29 is disposed in the direction of zero-th order diffraction light (angle of emission of θ) of the P-polarized laser beam 15a (angle of incidence of θ), this angle may be so selected as to minimize impingement upon the detector 29 of that scattered light which is produced from anything other than a foreign particle or fault on the surface 21 (for example, light diffractively scattered by a circuit pattern of a reticle).

With the rotation of the scanning mirror 13, the scanning spot 20 moves along a direction perpendicular to the sheet of the drawing, to optically scan the surface 21. Also, the scanning stage 22 relatively moves the surface 21 in a direction (depicted by an arrow in the drawing) perpendicular to the optical scan direction with the spot 20, whereby the surface 21 as a whole can be scanned two-dimensionally.

In the present embodiment, a particular notice is taken on three kinds of light, among those produced from the scanning spot 20 toward the photoelectric detector 29, that is: (1) zero-th order diffraction light 23 (P-polarized light) of the P-polarized laser beam 15a; (2) back scattered light 24 (P-polarized light plus S-polarized light) of the S-polarized laser beam 15b, depolarized by a foreign particle or fault; and (3) back scattered light 25 (S-polarized light) of the S-polarized laser beam 15b, produced by the circuit pattern formed on the surface 21. Here, the cause of depolarization attributable to a foreign particle or fault on the surface is that: Since generally the surface irregularity on such foreign particle or fault is large, when the light is irregularly reflected and scattered, the state of polarization is disturbed to generate a polarized component different from the plane of polarization of the input light. If, on the other hand, the surface is relatively uniform and smooth, such as the surface on a circuit pattern, the depolarization of scattered light is small.

The zero-th order diffraction light 23 of P-polarized light (shift frequency ω) produced in the direction toward the photoelectric detector 29 and the P-polarized light component of the back scattered light 24 (shift frequency ω+Δω) attributable to any particle or fault, have the same or coinciding plane of polarization. Therefore, they causes optical heterodyne interference. By photoelectrically converting this interference light, a beat signal is obtained. Namely, in the optical heterodyne method, since the zero-th order diffraction light 23 is a reference light and it comprises P-polarized light, the light that can interfere with this light to provide a beat signal, is only the scattered light 24 (among those back scattered) which has a P-polarized light component as a result of depolarization. This means that: if there is scattered light from a circuit pattern, it does not cause a beat signal; or alternatively, if a beat signal is produced, it is of very low level. Thus, the present embodiment assures inspection of any foreign particle or fault, with a very high sensitivity and a very high S/N ratio.

The above-described scattered light as received by the lens system 26 is then received by the polarization filter 27 having an optical property effective to pass only a P-polarized light component, whereby unwanted light components such as an S-polarized light component can be blocked. This effectively reduces beat signal noises attributable to unwanted mixture of noise polarized light. After this, the light passes through the slit-like aperture 28 and reaches the photoelectric detector 29. The detection signal obtained by the detector 29 is processed by the beat signal processing system 30, and the presence/absence of any foreign particle or fault is discriminated on the basis of the state of the beat signal.

In the present embodiment, the zero-th order diffraction light 23 comprising P-polarized light is used as a reference light and it is caused to interfere (heterodyne interference) with the P-polarized light resulting from depolarization, to thereby obtain a beat signal. However, even if the relationship of the P-polarization and the S-polarization is interchanged totally, the detection can be done in a similar way. An example of doing this may be that: the characteristics of the polarization beam splitter 15 are changed so as to provide a laser beam 15a of S-polarized component and a laser beam 15b of P-polarized component while, on the other hand, a polarization filter 27 having a property for passing only S-polarized light components is used.

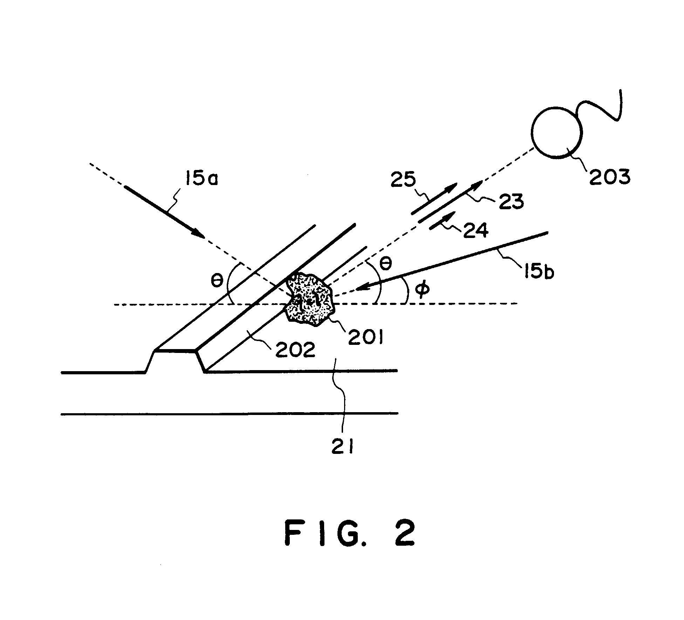

Next, generation of scattered light as well as detection of a beat signal in the present embodiment will be explained in greater detail. Figure 2 illustrates generation of scattered light in an occasion where a foreign particle and a circuit pattern are present in the neighbourhood of the position of a scanning spot. Denoted in the drawing at 201 is a foreign particle of a size of about 0.3 micron, adhered to the surface 21 to be inspected; at 202 is a circuit pattern; and at 203 is a beat signal detecting system including a polarization filter, as an example.

As described with reference to Figure 1, the P-polarized laser beam 15a having been modulated at a shift frequency ω) and the S-polarized laser beam 15b having been modulated at a shift frequency ω+Δω, are incident on the same spot position with respective angles of incidence of θ and φ. The beat signal detecting system 203 is disposed in the direction in which the zero-th order diffraction light is produced from the laser beam 15a by the surface 21 to be inspected and, with regard to the S-polarized laser beam 15b, the beat signal detecting system 203 is disposed in the direction of back scattering.

Here, since as compared with the size (about 0.3 micron) of particles to be inspected the scanning spot has a sufficiently large diameter of about 10 microns, irrespective of the presence or absence of such a particle the zero-th order diffraction light 23 can reach the beat signal detecting system 203 while the state of polarization of the input light is retained substantially unchanged. This can be explained from the fact that, in the phenomenon of diffraction of light, the higher the order of diffraction of light is, the more it depends on the high frequency component (spatial frequency) of the reflection surface while the zero-th order diffraction light depends on the low frequency component of the reflection surface. Namely, the zero-th order diffraction light is less affected by a minute structure within the spot.

Assuming now that the P-polarized laser beam 15a and the S-polarized laser beam 15b impinging on the surface 21 have respective electric fields $E_1$ and $E_2$, then they can be expressed as follows:

$$E_1 = Ep \bullet exp\{j(\omega t + \theta_1)\} \tag{1}$$

$$E_2 = Es \bullet exp[j\{(\omega + \Delta\omega)t + \theta_2\}] \tag{2}$$

Now, if the zero-th order diffraction light 23 from the scanning spot 20, the back scattered light 24 by the foreign particle and the back scattered light 25 by the circuit pattern are denoted by $F_1$, $R_1$ and $R_2$, respectively, then they can be expressed as follows:

$$F_1 = \alpha Ep \bullet exp\{j(\omega t + \theta'_1)\} \tag{3}$$

(where $\alpha$ is the efficiency of zero-th order diffraction)

$$R_1 = \Delta E_1 s \bullet exp[j\{(\omega + \Delta\omega)t + \theta'_2\}]$$

$$+ \Delta E_1 p \bullet exp[j\{(\omega + \Delta\omega)t + \theta'_2\}] \tag{4}$$

$$R_2 = \Delta E_2 s \bullet exp[j\{(\omega + \Delta\omega)t + \theta'_3\}] \tag{5}$$

Here, since only those having the same or coinciding plane of polarization cause interference and since any S-polarized component is blocked by a polarization filter included in the beat detecting system 203, the intensity I of a combined beat signal to be detected by the beat signal detecting system 203 can be expressed as follows:

$$I = \left| F_1 + R_1 + R_2 \right|^2$$

$$= (\alpha Ep)^2 + \Delta E_1 p^2 + 2\alpha Ep \Delta E_1 p \bullet cos(\Delta\omega t + \theta'_2 - \theta'_1) \tag{6}$$

The amplitude $\Delta E_1 p$ of the P-polarized component, produced as a result of depolarization by the particle defined by equation (4), is very small. Since, however, from the third term of equation (6), Ep is significantly larger than $\Delta E_1 p$, the output voltage of the beat signal detected by the beat signal detecting system 203 has a good sensitivity as compared with a case where the back scattered light 24 by the particle is detected directly.

Also, where the DC component and the AC component (frequency $\Delta\omega$) of the beat signal obtained in equation (6) are extracted selectively in accordance with an appropriate method, it is possible to avoid noise components such as stray light to thereby further enhance the S/N ratio.

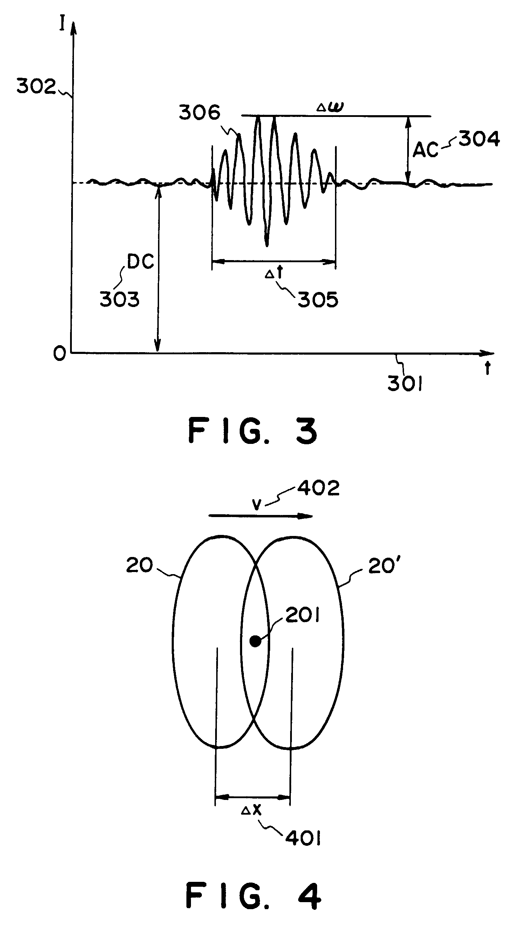

Now, the beat signal to be detected will be explained. Figure 3 shows an example of the waveform of such a beat signal. Denoted in the drawing at 301 is the axis which represents time t; at 302 is the axis which represents the intensity I of the signal outputted; at 306 is the beat signal to be detected; at 303 is the DC component of the beat signal; at 304 is the AC component of the beat signal; at 305 is the time width or period ($\Delta t$) in which the beat signal is detected.

As described hereinbefore, if there is no particle or fault within the scanning light spot, then no beat signal is detected. However, if there is any particle or fault, a beat signal of a frequency $\Delta\omega$ as depicted at 306 is produced in the time width $\Delta t$. This time width $\Delta t$ (305) in which the beat signal is produced is determined by the size of the scanning spot 20 and the scan speed of the spot 20 over the surface to be inspected. Namely, in Figure 4, the time period from a moment at which an end of the scanning spot 20 moving at a speed V (402) just reaches the particle 201 to a moment at which the scanning spot 20 comes just to the position 20', corresponds to the beat signal time width $\Delta t$ (305) in Figure 3.

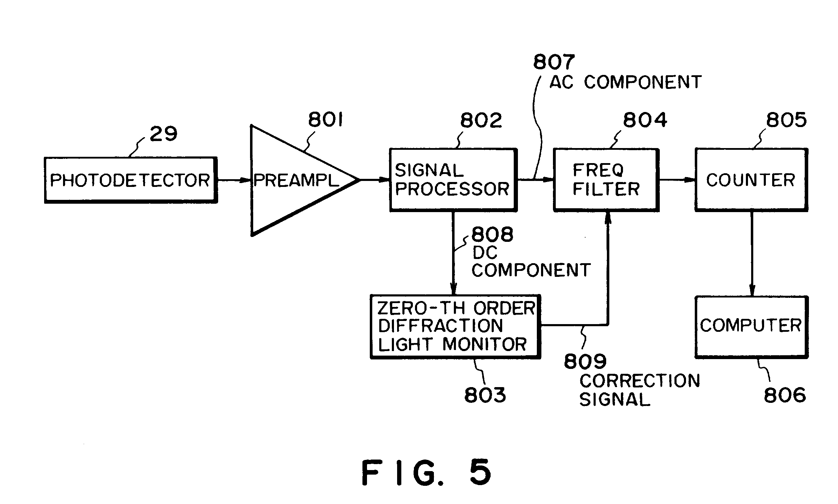

Referring now to Figure 5, details of an example of the structure of the beat signal processing system 30, for processing a beat signal detected, will be explained. Denoted in the drawing at 801 is a preamplifier for amplifying a beat signal detected by the photoelectric detector 29; at 802 is a signal processing system for detecting individually the DC component 808 and the AC component 807 of the amplified beat signal; at 803 is a zero-th order diffraction light monitor system for monitoring any change in intensity of the zero-th order diffraction light 23, through detection of the DC component 808; at 809 is a correction signal for correcting a change in intensity of the zero-th order diffraction light 23 as detected by the monitoring; at 804 is a frequency filter for extracting a signal of frequency $\Delta\omega$ of the detected AC component, for correction with the correction signal 809; at 805 is a counter for counting the number of particles or faults on the basis of comparison of the output of the frequency filter with a certain threshold for discrimination of a foreign particle or fault; and at 806 is a computer for memorizing and/or displaying the number of particles or faults or the positions of them on the surface 21.

From equation (6), the AC component 807 and the DC component 808 of the beat signal detected by the detector 29 can be expressed as follows:

$$\text{AC comp.} = 2\alpha Ep\Delta E_1 p \bullet \cos(\Delta\omega t + \theta'_2 - \theta'_1) \tag{7}$$

$$\text{DC comp.} = (\alpha Ep)^2 + \Delta E_1 p^2 \simeq (\alpha Ep)^2 \tag{8}$$

From equation (7), it is seen that the amplitude of the AC component of the beat signal is proportional to the intensity of the zero-th order diffraction light and the back scattered light from a particle or fault.

When the surface 21 is scanned with the scanning spot 20, there is a possibility that the intensity of the zero-th order diffraction light changes due to the effect of the circuit pattern or the like. From equation (8), such a change can be given by detecting the DC component. Therefore, in order to assure measurement of good S/N ratio without being affected by this effect, correction is made on the basis of monitoring the DC component of the beat signal represented in equation (8) through the zero-th order diffraction light monitor 803. A change in intensity of the zero-th order diffraction light 23 can be corrected, for example, by changing the amplification rate to the frequency-filtered signal in accordance with the correction signal 809. This assures that the intensity of the output pulse of the frequency filter 804 is correctly in a proportional relationship only with the intensity of scattered light from a foreign particle. Then, in respect to the noise level, a threshold is set in the counter 805 and discrimination is made as to whether the output pulse results from a foreign particle or fault, or it is a noise resulting from a circuit pattern or the like. The result of discrimination is inputted to the computer 806, wherein it is processed for data storing or displaying.

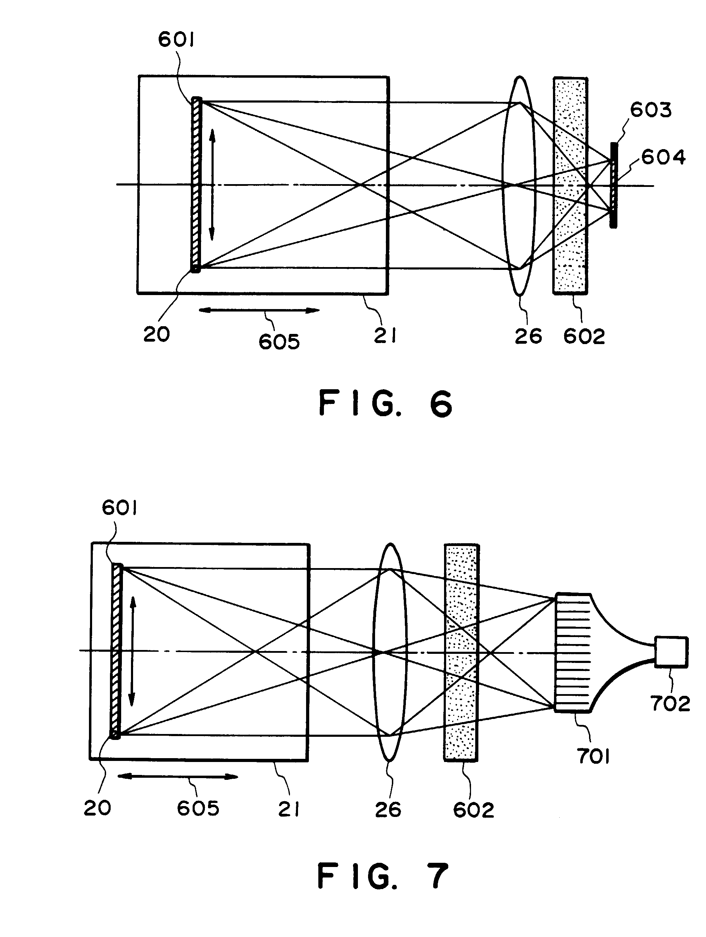

Now, the optical arrangement of the detection system of the present embodiment will be explained in greater detail. Figure 6 shows the detection system of Figure 1, as viewed from the above. Denoted in the drawing at 601 is the optical scanning region which is the region to be scanned with the scanning spot 20 through the scanning mirror; at 602 is a filter system which includes the polarization filter 27 and the aperture 28 of Figure 1, for example; at 603 is the detection surface of the photoelectric detector; at 604 is the imagewise region of the optical scanning region 601 as imaged by the lens system 26; and at 605 is the direction of scan as determined by the scanning stage system.

With this structure, even when the scanning spot 20 is at any location within the optical scanning region 601, the zero-th order diffraction light (23) in Figure 1 as well as the scattered light (24, 25) can be received by the lens system 26 and, after interception of any stray light or unwanted S-polarized light components by the filter system 602, they can be projected on the detection surface 603 of the photoelectric detector. Thus, the structure that enables, in a scanning optical system using a scanning mirror or the like, the beat signal detection based on optical heterodyne method is assured.

A modified form is illustrated in Figure 7 wherein a bundle of optical fibers 701 is disposed at the position of the detection surface, for guiding the light to a detection surface of a photoelectric detector 702. Also this arrangement assures detection of a beat signal in the optical scanning region 601.

With the embodiment described hereinbefore, the following advantageous effects are provided:

(1) Only the light depolarized by a particle or fault to be detected, produces a beat signal. Any scattered light from a circuit pattern does not substantially participate in producing a beat signal. Therefore, the particle or fault can be detected with goon S/N ratio.

(2) Because the heterodyne method is used, a higher S/N ratio is attainable as compared with a case wherein the intensity of weak scattered light from a particle is to be measured directly.

(3) Optical scanning through a scanning mirror ensures heterodyne detection, and a large increase of throughput is attainable.

(4) It is possible to detect a very small particle of a size of 0.3 micron or less with good sensitivity (which particle can not be easily detected with the conventional technique), while discriminating it from a circuit pattern.

Embodiment 2

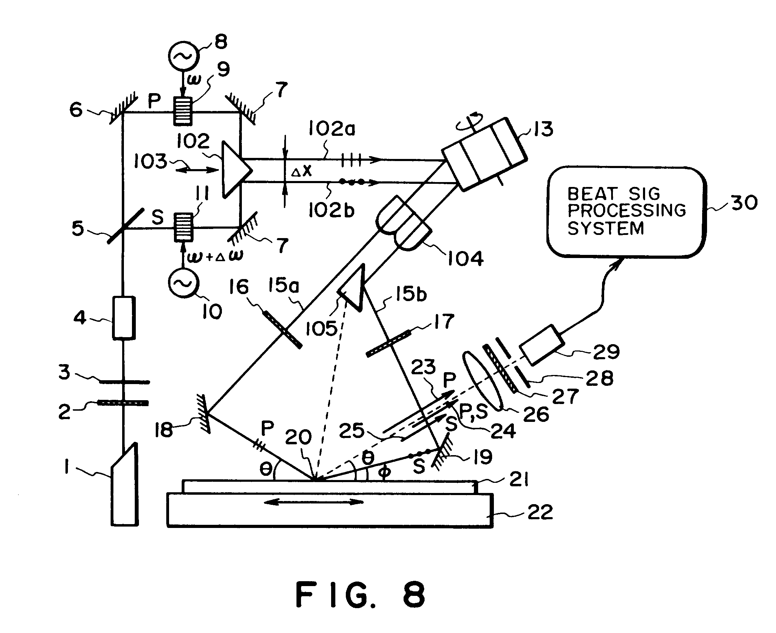

Now, a second embodiment of the present invention will be explained. Figure 8 shows this embodiment, and like numerals as those used in Figure 1 are assigned to corresponding or similar elements. Description will be made mainly on the differences of this embodiment from the preceding embodiment.

Denoted in the drawing at 102 is a rectangular prism for applying two laser beams to a scanning mirror 13 in the form of spatially separated parallel light beams; denoted at 104 is an f-$\theta$ lens system; and at 105 is a mirror edge for directing the parallel light beams in different directions.

The structure for providing two laser beams having different frequencies and different directions of polarization, that is, a P-polarized laser beam modulated by an acousto-optic device 9 at a shift frequency $\omega$ and an S-polarized laser beam modulated by an acousto-optic device 11 at a shift frequency $\omega+\Delta\omega$, is substantially the same as that of the preceding embodiment. As described hereinbefore, as a modification, only one acousto-optic device may be used to modulate only one of the two laser beam at a shift frequency $\Delta\omega$, or a Zeeman laser may be used. As a further alternative, an injection current to a semiconductor laser may be modulated.

In this embodiment, the two modulated, linearly polarized laser beams are not superposed one upon another but, by using the mirror 7 and the rectangular prism 102, parallel laser beams 102a and 102b spaced by a distance $\Delta x$ are produced. These laser beams 102a and 102b comprises two linearly polarized lights having mutually orthogonal planes of polarization and having a relative shift frequency difference $\Delta\omega$. The spacing $\Delta x$ of these parallel light beams can be easily adjusted to a desired one by moving the rectangular prism 102 in the direction of an arrow 103.

The two laser beams 102a and 102b are directed to a scanning optical system provided by the scanning mirror 13 and the f-$\theta$ lens system 104. Here, the f-$\theta$ lens system 104 comprises combined two f-$\theta$ lenses having the same optical function. Of the parallel light beams emanating from the f-$\theta$ lens system 104, one goes straight while the other is deflected by the edge mirror 105, whereby they are separated into a P-polarized laser beam 15a (shift frequency $\omega$) and an S-polarized laser beam 15b (shift frequency $\omega+\Delta\omega$) advancing in different directions. The structure and function of the remaining portion are essentially the same as those of the first embodiment, and description of them will be omitted here.

In the present embodiment, the zero-th order diffraction light 23 comprising P-polarized light is used as a reference light and it is caused to interfere (heterodyne interference) with the P-polarized light resulting from depolarization, to thereby obtain a beat signal. However, even if the relationship of the P-polarization and the S-polarization is interchanged totally, the detection can be done in a similar way. An example of doing this may be that: the characteristics of the polarization beam splitter 5 are changed so as to provide a laser beam 102a (15a) of S-polarized component and a laser beam 102b (15b) of P-polarized component while, on the other hand, a polarization filter 27 having a property for passing only S-polarized light components is used.

With the structure of the present embodiment wherein the edge mirror 105 is used to spatially separate the P-polarized laser beam 15a and the S-polarized laser beam 15b, it is possible to provide spatially separated, linearly polarized laser beams having different shift frequencies, without using an elongated polarization beam splitter. Generally, it is not easy and requires a high cost to prepare an elongated polarization beam splitter having a uniform light extinction ratio. Thus, with the present embodiment, in addition to the advantageous effects of the first embodiment, it is possible to facilitate the reduction of cost. Also, the mixture of unwanted polarized light during the scan can be avoided (i.e. a higher extinction ratio is attainable), and thus further enhancement of S/N ratio is assured.

Embodiment 3

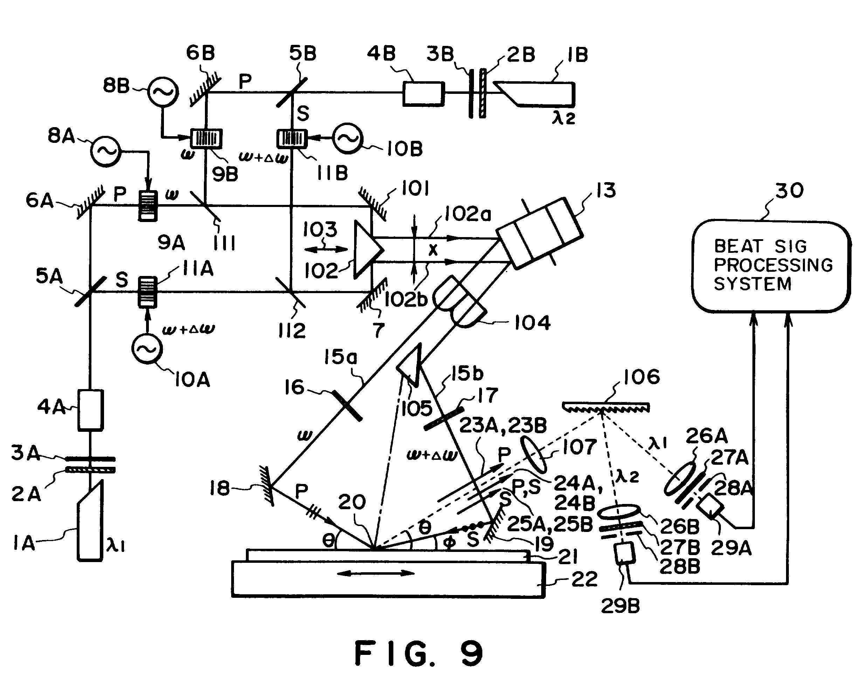

Referring now to Figure 9, a third embodiment which may correspond to an improved form of the second embodiment, will be explained. Like numerals as of those of the preceding embodiments are assigned to corresponding or similar elements. Denoted in the drawing at 1A and 1B are laser light sources for producing laser beams of different wavelengths $\lambda_1$ and $\lambda_2$, respectively. Specifically, the source 1A comprise an Ar$^+$ laser light source adapted to produce a laser beam of a wavelength $\lambda_1 = 0.488$ micron, while the source 1B comprises a He-Ne laser light source adapted to produce a laser beam of a wavelength $\lambda_2 = 0.6328$ micron. Denoted at 2A and 2B are polarizing plates; at 3A and 3B are filter systems; at 4A and 4B are collimator optical systems; at 5A and 5B are polarization beam splitters each for separating a laser beam into two mutually orthogonal, polarized components; at 9A, 9B, 11A and 11B are acousto-optic devices each for modulating a laser beam at an appropriate shift frequency; and at 111 and 112 are half mirrors each for combining light beams of wavelengths $\lambda_1$ and $\lambda_2$. Denoted at 106 is a spectroscope which uses a diffraction grating, for example; at 26A and 26B are lens systems each for guiding scattered light from a scanning spot 20 to a photoelectric detector; at 27A and 27B are polarization filters; at 28A and 28B are slit-like apertures; at 29A and 29B are photoelectric detectors; and at 30 is a beat signal processing system.

The laser beam 102a obtainable through the optical arrangement of this embodiment, corresponds to a combination of P-polarized light of a wavelength $\lambda_1$ and P-polarized light of a wavelength $\lambda_2$ as modulated respectively at a shift frequency $\omega$ and combined by means of the half mirror 111. On the other hand, the laser beam 102b corresponds to a combination of S-polarized light of a wavelength $\lambda_1$ and S-polarized light of a wavelength $\lambda_2$ as modulated respectively at a shift frequency $\omega+\Delta\omega$ and combined by means of the half mirror 112. After being scanned by the scanning optical system, these laser beams are separated by the edge mirror 105 into a P-polarized laser beam 15a (wavelengths $\lambda_1$ and $\lambda_2$) and an S-polarized laser beam 15b (wavelengths $\lambda_1$ and $\lambda_2$), and they are converged into the same spot 20 with different angles of incidence.

In the present embodiment, a particular notice is taken on the following six kinds of lights, among those emitting from the scanning spot 20 toward the detection optical system:

(1) Zero-th order diffraction light 23A (P-polarized light; wavelength $\lambda_1$) of the P-polarized laser beam 15a;
(2) Zero-th order diffraction light 23B (P-polarized light; wavelength $\lambda_2$) of the P-polarized laser beam 15a;

(3) Backward scattered light 24A (P-polarized light plus S-polarized light; wavelength $\lambda_1$) resulting from a foreign particle or fault;

(4) Backward scattered light 24B (P-polarized light plus S-polarized light; wavelength $\lambda_2$) resulting from a foreign particle or fault;

(5) Backward scattered light 25A (S-polarized light; wavelength $\lambda_1$) resulting from a circuit pattern; and

(6) Backward scattered light 25B (S-polarized light; wavelength $\lambda_2$) resulting from a circuit pattern.

In the present embodiment, the light received by a relay optical system 107 is separated by the spectroscope 106 comprising a diffraction grating, into two components of wavelengths $\lambda_1$ and $\lambda_2$, and these components are then detected separately. This assures that, for each of the two wavelengths $\lambda_1$ and $\lambda_2$, a beat signal attributable to a foreign particle or fault can be detected. The beat signal processing system 30 operates to process two signals in a similar way and, if a foreign particle or fault is detected with respect to at least one of them, then it is discriminated that there is a foreign particle or fault.

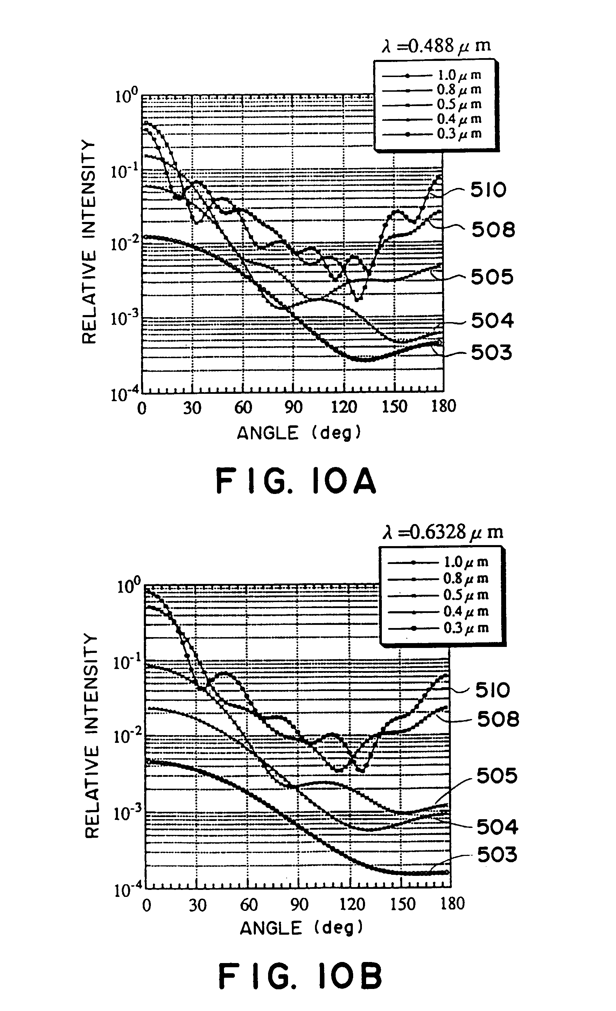

Here, advantageous effects of the present embodiment wherein laser beams of different wavelengths $\lambda_1$ and $\lambda_2$ are used and beat signal detection is made for each wavelength, will be explained. Figures 10A and 10B each shows an intensity distribution of light scattered by a particulate as determined in accordance with the Mie scattering theory. The graph of Figure 10A corresponds to a case where the wavelength of input light is 0.488 micron (Ar+ laser), and the graph of Figure 10B corresponds to a case where the wavelength of input light is 0.6328 micron (He-Ne laser). The axis of abscissa in each graph corresponds to the direction of propagation of the scattered light, and the direction of advancement of the light impinging on the particulate is represented by 0 (zero) deg. while the direction opposite to it is represented by 180 deg. Namely, 0 (zero) deg. represents the direction of forward scattering while 180 deg. represents the direction of back scattering. On the other hand, the axis of ordinate of each graph corresponds to the relative intensity of light at a certain angle of scattering. Curves 503, 504, 505, 508 and 510 in each graph provides the scattering distribution curves as defined in cases where the diameter of the particulate is 0.3 micron, 0.4 micron, 0.5 micron, 0.8 micron and 1.0 micron, respectively.

It is to be noted here that each scattering intensity distribution curve in Figures 10A and 10B is determined when a plane wave is projected to a particulate being floating in a space and, therefore, in an exact sense it can not be applied to a foreign particle adhered to the surface being examined. However, where the input light is obliquely incident and back scattered light is detected as in the present embodiment, because of small back scattering of light from the surface being examined it may be relied upon as a qualitative explanation.

From the graphs of Figures 10A and 10B, it is seen that, if the wavelength of light impinging on one and the same particulate changes, the light intensity at a certain scattering angle changes. For example, regarding the back scattered light and the angle of scattering of 150 deg., the light of wavelength 0.488 micron has a larger scattered light intensity for the cases of the particulate diameters of 0.3 micron and 0.5 micron. However, to the contrary, for the particulate diameter of 0.4 micron, the light of wavelength 0.6328 micron has a larger scattered light intensity.

In the present embodiment, any foreign particle or fault is detected with the two parameters obtained respectively from these wavelengths and, thus, "manifold" measurement is executed. Therefore, it is possible to complement, with one of the two wavelengths, such particle diameter region to which the other wavelength has a lower sensitivity. As a result, the measurement can meet particles of a variety of sizes. In other words, the present embodiment provide advantages of reduced sensitivity variation to the particle size and widened dynamic range to the particle size for inspection.

While in the present embodiment two different wavelengths $\lambda_1$ and $\lambda_2$ are used to obtain two parameters for attainment of "manifold" measurement, three or more wavelengths may of course be used. This ensures further enhancement of measurement precision.

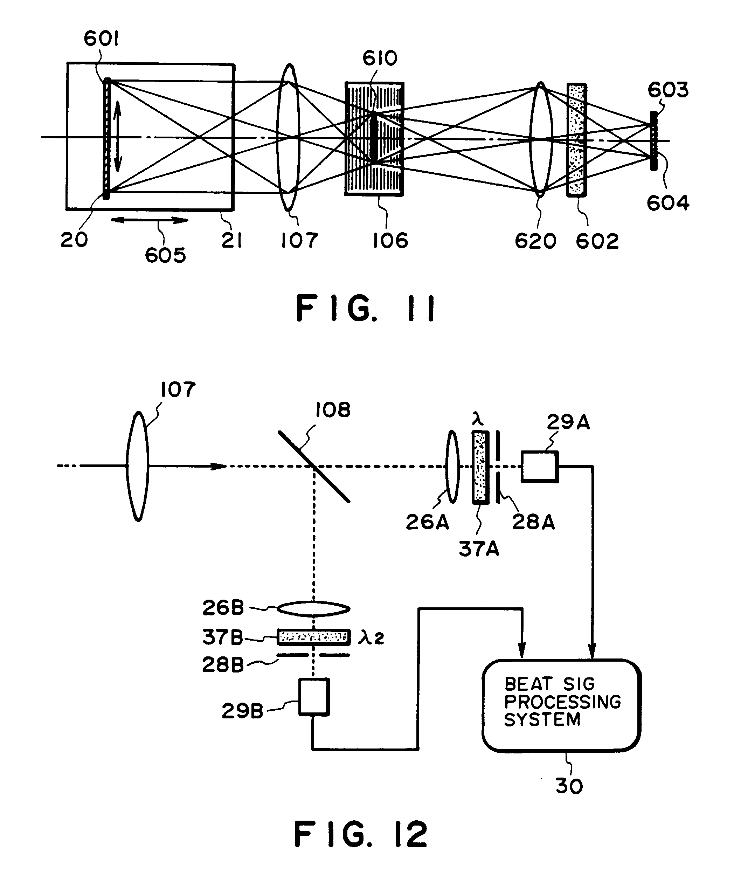

Now, the optical arrangement of the detection system of the present embodiment will be explained in greater detail. Figure 11 shows the detection system of Figure 9, as viewed from the above. Denoted in the drawing at 601 is the optical scanning region which is the region to be scanned with the scanning spot 20 through the scanning mirror; at 605 is the direction of scan as determined by the scanning stage system; at 610 is the imagewise region on the spectroscope 106 as imaged by the relay optical system 107; and at 620 is a reduction optical system including the lenses 26A and 26B in Figure 9. Denoted at 602 is a filter system which includes the polarization filters 27A and 27B as well as the apertures 28A and 28B of Figure 1, for example; at 603 is the detection surface of the photoelectric detector; at 604 is the imagewise region of the optical scanning region 601 as imaged by the lens system 26.

With this structure, even when the scanning spot 20 is at any location within the optical scanning region 601, the zero-th order diffraction light (23A, 23B) in Figure 9 as well as the scattered light (24A, 24B, 25A, 25B) can be received by the relay lens 107 and imaged on the spectroscope 106. Then, the light from the spectroscope divided with respect to spectrum is received by the reduction optical system 620 and, after interception of any stray light or unwanted S-polarized light components by the filter system 602, it is projected on the detection surface 603 of the photoelectric detector. Thus, the structure that enables, in a scanning optical system using a scanning mirror or the like, the beat signal detection based on optical heterodyne method is assured.

Figure 12 shows a modified form wherein the spectroscope comprising a diffraction grating is replaced by a half mirror. More specifically, denoted in the drawing at 108 is the half mirror; at 26A and 26B are reduction optical systems; at 37A and 37B are filter systems each comprising a wavelength selecting filter for selectively passing only a wavelength $\lambda_1$ or $\lambda_2$ and a polarization filter for blocking unwanted S-polarized components; at 28A and 28B are apertures; and at 29A and 29B are photoelectric detectors. The scattered light received by the relay optical system 107 is divided by the half mirror 108 into two, and light of a wavelength $\lambda_1$ is extracted by means of the filter system 37A while light of a wavelength $\lambda_2$ is extracted by means of the filter system 37B, whereby signals related to respective wavelengths can be produced.

With this embodiment of the present invention, owing to "manifold" measurement of a particle or fault using different wavelengths, the following advantageous effects are provided in addition to those of the second embodiment:

(1) The detection sensitivity variation to the particle size is small; and
(2) The dynamic range to the particle size for inspection is wide.

Embodiment 4

Next, a fourth embodiment of the present invention will be explained. While in the third embodiment different wavelengths are used for "manifold" measurement, in this embodiment such "manifold" measurement is assured by using different scattering angle components.

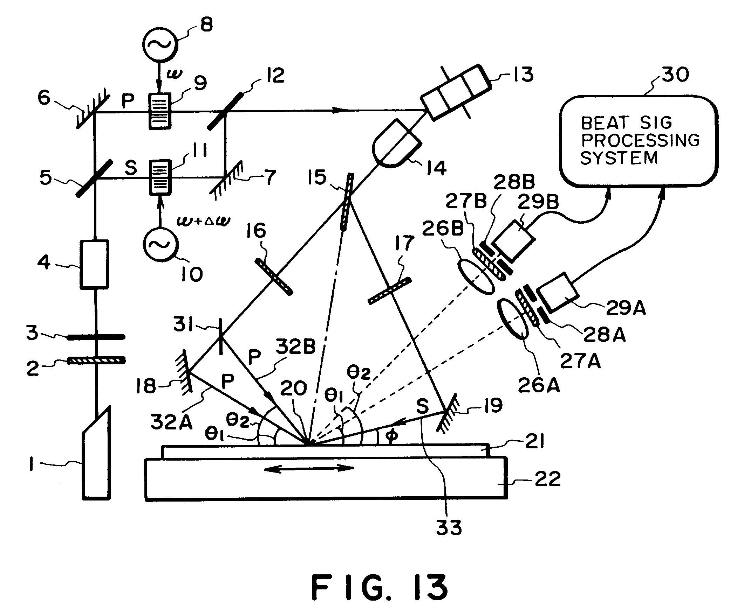

Figure 13 shows the arrangement of this embodiment. Like numerals as of those of Figure 1 are assigned to corresponding or similar elements. In this embodiment, as compared with the structure of Figure 1, a half mirror 31 is added to ensure that two beams 32A and 32B are projected on the same position of the light spot 20 at different angles $\theta_1$ and $\theta_2$. Disposed in the direction of zero-th order diffraction of the beam 32A is a first detection optical system (26A, 27A, 28A, 29A) while, on the other hand, disposed in the direction of zero-th order diffraction of the beam 32B is a second detection optical system (26B, 27B, 28B, 29B). Stating in a different way, the first and second detection systems are disposed in the directions of different back scattering angles, with respect to the S-polarized laser beam 33. Beat signal processing system 30 operates to process two signals, obtained through the first and second detection optical systems, in a similar manner as that in the preceding embodiments. If any foreign particle or fault is detected with respect to at least one of them, it is discriminated that there is a foreign particle or fault on the surface being examined.

As seen from the graphs of Figure 10A and 10B, depending from the angle of scattering, different information is obtainable from the scattered light produced from the position being inspected. Thus, by detecting scattered components of different angles to ensure "manifold" measurement as in the present embodiment, it is possible to enhance the precision of detection. While in this embodiment scattered components in two directions are detected, those in three or more directions may of course be detected. This effectively assures further enhancement of the inspection precision.

Embodiment 5

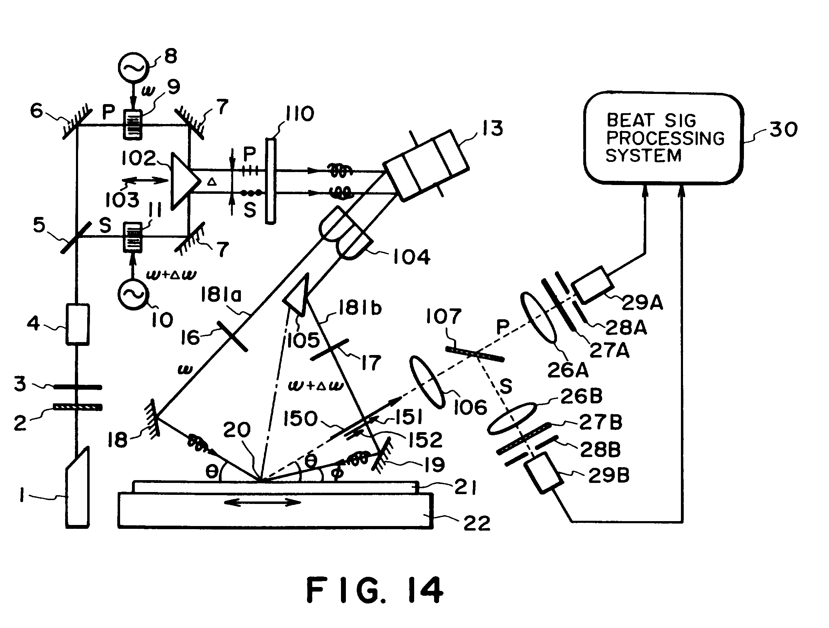

Figure 14 shows a fifth embodiment of the present invention, and like numerals as of those used in Figure 8 are assigned to corresponding or similar elements. While in the preceding embodiments lights in different states of linear polarization are used to cause heterodyne interference, in the present embodiment circularly polarized lights are used in place of them. An important structural feature of the present embodiment resides in the provision of a quarter ($\lambda/4$) phase difference plate 110 disposed between a rectangular mirror 102 and a scanning mirror 13, and a detection optical system including and following a polarization beam splitter 107.

In Figure 14, the optical arrangement for providing two laser beams, one is P-polarized light with a shift frequency $\omega$ and the other is S-polarized light with a shift frequency $\omega+\Delta\omega$, is of the same structure as of the Figure 8 embodiment. These two linearly polarized lights pass through the quarter phase plate 110, by which they are transformed into a circularly polarized beam with a shift frequency $\omega$ and a circularly polarized beam with a shift frequency $\omega+\Delta\omega$. Here, these two circularly polarized lights are in an oppositely rotating relationship. Through the scanning optical system like that of the preceding embodiment, these light beams are directed to the surface to be inspected to scan the same.

In the present embodiment, a particular notice is taken on the following three kinds of light, among the lights to be emitted from the scanning spot 20 toward the detection optical system:

(1) Zero-th order diffraction light 150 which is circularly polarized light (P component = S component);
(2) Back scattered light 151 from a particle or fault, which is elliptically polarized light (P component > S component); and
(3) Back scattered light 152 from a circuit pattern, which is circularly polarized light (P component = S component).

These scattered lights 150, 151 and 152 are separated into P-polarized component and S-polarized component, by means of the polarization beam splitter 107. The P-polarized component is received by a detection optical system 26A, and anything therein other than the P-polarized component is completely removed by a polarization filter 27A, for reduction of any beat signal noise due to mixture of unwanted polarization component. After this, it passes through a slit-like aperture 28A and is received by a photoelectric detector 29A, whereby it is photoelectrically converted. Similarly, the S-polarized component is received by a detection optical system 26B, and anything therein other than the S-polarized component is completely removed by a polarization filter 27B, for reduction of any beat signal noise. After this, it passes through a slit-like aperture 28B and it is photoelectrically converted by a photoelectric detector 29B. In this manner, a beat signal corresponding to the P-polarized component is obtainable from the detector 29A, while a beat signal corresponding to the S-polarized component is obtainable from the detector 29B.

The detection of any particle or fault in the present embodiment is based on the phenomenon that the back scattered light from the particle or fault has a larger P-polarized component as compared with an S-polarized component. More specifically, if there is a particle or fault, the beat signal corresponding to the P-polarized component becomes larger than that corresponding to the S-polarized component, and the beat signal processing system 30 carries out the discrimination on the basis of the detection signals from the detectors 29A and 29B. As an example, if the comparison of the amplitudes of the two beat signals turns out P>S, it is discriminated that there is a particle or fault. If P≈S is turned out, it is discriminated that there is no particle or fault.

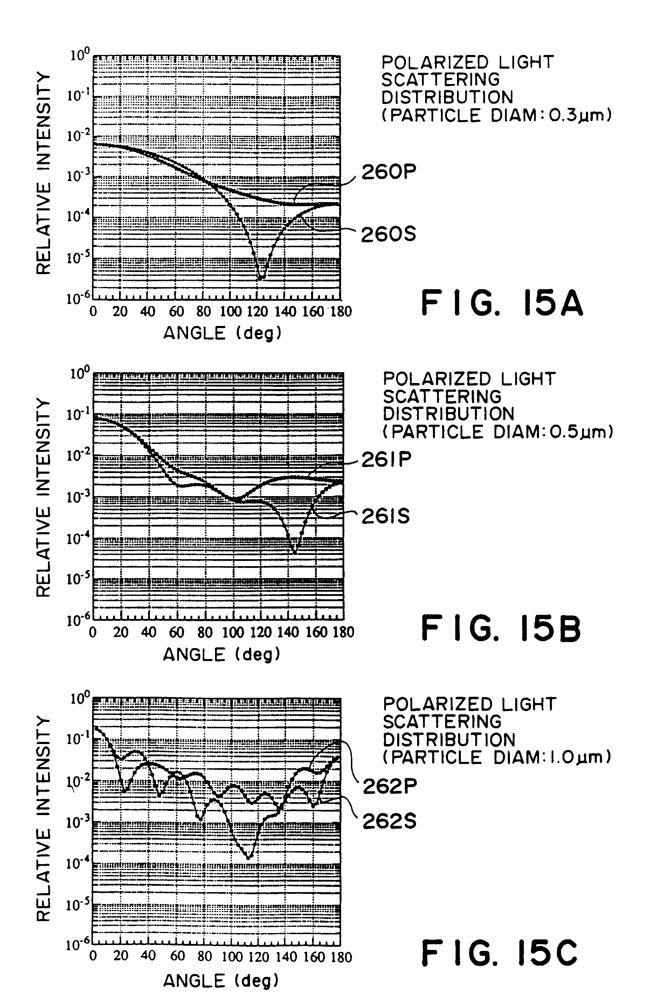

Referring now to the graphs of Figures 15A - 15C, the reason why a larger P-polarized component is included in the back scattered light from a particle or fault will be explained. Figures 15A - 15C are the graphs wherein, with respect to each of the P and S components, the intensity distribution of scattered light from a particulate as determined in accordance with the Mie scattering theory, is illustrated. More specifically, in Figures 15A - 15C, there are illustrated curves of distributions of the P-polarized light scattering and the S-polarized light scattering in the cases of particulate diameters of 0.3 micron, 0.5 micron and 1.0 micron, respectively. The axis of abscissa in each graph denotes the direction of propagation of the scattered light, and the direction of advancement of the light inputted to the particulate is represented by 0 (zero) deg. while the direction opposite thereto is represented by 180 deg. Namely, the "zero deg. " represents the direction of forward scattering while the "180 deg." represents the direction of back scattering. Reference characters 260p, 261p, and 261p denote curves of scattering distribution of the P-polarized light in the cases of particulate diameters of 0.3 micron, 0.5 micron and 1.0 micron, respectively. Similarly, reference characters 260s, 261s and 262s denote curves of scattering distribution of the S-polarized light in the cases of particulate diameters of 0.3 micron, 0.5 micron and 1.0 micron, respectively.

Now, the back scattered light (140 - 160 deg.) from a particulate will be considered. From the graph of Figure 15A, it is seen that at the side of the back scattering the P-polarized component is larger than the S-polarized component. Also in the graphs of Figure 15B and 15C, at the side of the back scattering, the P-polarized component is larger than the S-polarized component. Generally, there occurs disturbance of polarization due to depolarization attributable to a particle or fault. However, the change from the P-polarization to the S-polarization and the change from the S-polarization to the P-polarization are approximately of the same magnitude. As a consequence, even by the depolarization attributable to the particle or fault, the superiority of the P-polarized component in the back scattered light is not affected. Thus, it can be appropriately said that, if there is a particle or fault, the P-polarized component of the back scattered light is relatively large.

In the present embodiment as described, while utilizing the phenomenon that in the scattering of light from a particle or fault the P-polarized component of the scattered light is relatively larger, beat signals corresponding to the P and S components are detected and mutually compared. This ensures detection of a particle or fault at a high S/N ratio even where a scattered light from a circuit pattern is mixed.

<u>Embodiment 6</u>

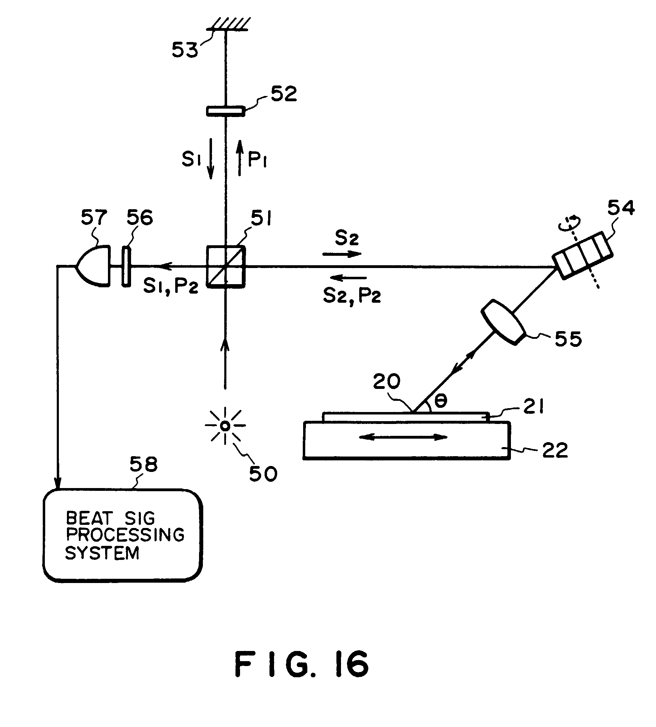

Referring now to Figure 16, a sixth embodiment of the present invention will be explained. Denoted in the drawing at 50 is a light source system; at 51 is a polarization beam splitter; at 52 is a quarter wave plate; at 53 is a reflection mirror; at 54 is a scanning mirror such as a polygonal mirror or galvano mirror; at 55 is an f-θ lens system; at 56 is a polarization filter; at 57 is a detection system including a photoelectric detector; and at 58 is a beat signal processing system.

The light source system 50 is adapted to provide a laser beam of two wavelengths having a small difference in frequency, in mutually orthogonal planes of polarization, and it comprises a Zeeman laser, for example. Of course, the light source system may have the structure as of the preceding embodiment. The light from the light source system 50 is inputted to the polarization beam splitter 51. The P-polarized laser beam with a frequency $f_1$ passes through the beam splitter 51 while the S-polarized laser beam with a frequency $f_2$ is reflected by the beam splitter 51, whereby two frequency components are separated and two light beams are separated.

The P-polarized laser beam $P_1$ passed through the polarization beam splitter 51 then goes through the quarter wave plate 52 and it is reflected by the mirror 53 in an exactly reverse direction. The mirror 53 may desirably comprise a corner cube prism or a cat's eye reflector capable of returning a received light along a path on or in parallel to to the oncoming path. The reflected light passes again the quarter wave plate 52 and enters the polarization beam splitter 51. Here, during the period from the exit from the polarization beam splitter 51 to the second incidence on the same beam splitter, the light passes through the quarter wave plate 52 twice. Thus, the P-polarized S-polarized laser beam $P_1$ is transformed into an laser beam $S_1$ whose plane of polarization being rotated by 90 deg. When this S-polarized laser beam with a frequency $f_1$ is incident on the beam splitter 51, since it is now S-polarized light, it is reflected thereby and is directed toward the detection system 57 as a reference light $S_1$.

On the other hand, the S-polarized light $S_2$ with a frequency $f_2$ inputted from the light source system 50 to the polarization beam splitter 51 and reflected thereby, is reflected by the scanning mirror 54 such as a polygonal mirror or a galvano mirror. Then, it goes through the f-θ lens 55 and it is projected onto the surface 21, to be inspected, at an angle of incidence of θ as a scanning spot 20, by which the surface can be scanned along a direction perpendicular to the sheet of the drawing. As regards the incidence angle θ, it is so selected as to provide a high sensibility to scattered light. Since it is not necessary to project two light beams on the same point as in the preceding embodiment, there is a wide design latitude. The scanning stage 22 serves to move the surface 21 in a direction (depicted by an arrow) perpendicular to the aforementioned scanning direction, such that the surface 21 as a whole can be scanned two-dimensionally.

As described hereinbefore, if there is a particle or fault or a circuit pattern on the surface 21, the S-polarized laser beam is scattered in various directions. If it is scattered by a particle or fault, due to depolarization the P-polarized component is scattered while being mixed into the S-polarized component. If the light is scattered from a circuit pattern, there occurs substantially no depolarization and the light is scattered with the plane of polarization of the S-polarized light being retained.

Of the light scattered from the scanning spot in response to the impingement of the laser beam, the light scattered in the direction just on the direction of incidence goes through the f-θ lens 55 and is reflected by the scanning mirror 54 toward the polarization beam splitter 51. While originally this light is the S-polarized laser beam with a frequency $f_2$, only the P-polarized component of the light depolarized due to the scattering by a particle or fault can pass through the polarization beam splitter 51 and can be directed toward the detection system 57 as a measurement light $P_2$. Since the S-polarized component therein is reflected by the beam splitter 51, it is not directed to the detection system 57.

It is to be noted that the optical arrangement is so structured that the optical path difference applied to the two light beams, from the separation of them by the polarization beam splitter 51 to the re-combination of them in response to the second impingement of them upon the beam splitter 51, is maintained within the range of coherent length of a used laser beam so as to assure the optical interference.

The two light beams directed to the detection system 57 and having different frequency components, i.e. the reference light $S_1$ and the measurement light $P_2$, have mutually orthogonally intersecting planes of polarization. The polarization filter 56 is so disposed to have its axis of transmission inclined by 45 deg. to both of these planes of polarization. Thus, when the two light beams pass the polarization filter 56, only the components of them corresponding to the axis of transmission can be transmitted therethrough, such that these two frequency components can have coinciding planes of polarization. Since the two light beams having coinciding planes of polarization have a small difference in frequency, they cause heterodyne interference. The resultant interference light is photoelectrically converted by the photoelectric detector of the detection system 57, whereby a beat signal is obtained. The signal from the detection system 57 is applied to the beat signal processing system 58 and, like the preceding embodiment, evaluation of a foreign particle or a fault is executed.

Similar detection is attainable even when the relationship between the P-polarization and the S-polarization is inverted totally. An example of this may be that: the arrangement of the light source system 50, the polarization filter 56, the detection system 57 and the beat signal processing system 58 is modified so as to change the direction of projection of light from the light source system 50 to the polarization beam splitter 51 as well as the direction of light exit from the beam splitter 51 to the detection system 57, such that the laser beam reflected by the polarization beam splitter toward the mirror 53 comprises S-polarized light while the laser beam passed through the polarization beam splitter toward the scanning mirror 54 comprises P-polarized light.

In the present embodiment, only one light beam scans the surface to be inspected. Thus, it is not necessary to use an arrangement for registering scanning spots of two light beams as in the preceding embodiment. Additionally, the limitation to the incidence angle θ is small. Further, since the scattered light from a particle or fault goes reversely through the scanning optical system, the optical axis alignment for the scattered light and the reference light is easy and, additionally, no specific optical arrangement is necessary therefor. Owing to these advantages, simplification of structure and reduction of cost are assured. Moreover, since the reference light does not scan the surface to be inspected, the intensity of the reference light does not change, and the signal detection is stable.

Embodiment 7

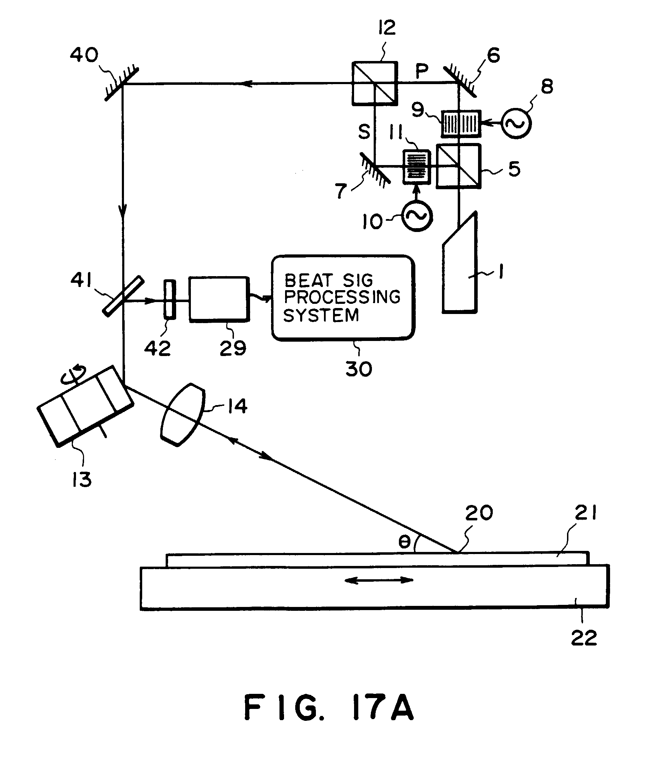

Figure 17A shows the structure according to a seventh embodiment wherein further structural simplification is aimed at. Like numerals as of those used in the preceding embodiments are assigned to corresponding or similar elements. Denoted in the drawing at 40 is a reflection mirror; at 41 is a half mirror; and at 42 is a polarization filter provided to selectively transmit only P-polarized light or S-polarized light.

In the structure of the present embodiment, the light source system for providing a combined beam of a P-polarized laser beam modulated with a shift frequency $\omega$ and an S-polarized laser beam modulated with a shift frequency $\omega+\Delta\omega$, is like that of the preceding embodiment. This may of course be replaced by use of a Zeeman laser or control of an injection current to a semiconductor laser. The provided laser beam is reflected by the mirror 40, and light passing through the half mirror 41 enters a scanning optical system comprising a scanning mirror 13 and an f-$\theta$ lens 14 at an incidence angle $\theta$ by which it is scanningly deflected. Namely, in this embodiment, a single laser beam containing both of the P-polarized light and the S-polarized light with a frequency difference, is projected to a spot 20.

Here, if there is a particle or fault or a circuit pattern within the spot 20, scattering of light occurs. Of the light scattered, the components scattered along the path of incidence of light go via the f-$\theta$ lens 14 and the scanning mirror 13 and reach the half mirror 41. Then, the light components reflected by the half mirror 41 are received by a polarization filter 27, by which the polarization planes of them are registered to the P-polarization or S-polarization, and then a signal is detected by a photoelectric detector 29. This signal is then processed by a beat signal processing system 30 as in the preceding embodiment.

Here, the principle of detecting a particle or fault in the present embodiment will be explained. The linearly polarized laser beam projected to the scanning spot 20 and having a P-polarized component (shift frequency $\omega$) and an S-polarized component (shift frequency $\omega+\Delta\omega$), is depolarized by light scattering by the particle or fault, and thus an S-polarized P-polarized component with a shift frequency $\omega$ and a component with a shift frequency $\omega+\Delta\omega$ are newly produced. This depolarization is caused mainly by a particle or fault, and it substantially hardly occurs by a circuit pattern, as discussed in the foregoing. Thus, with the scattering by a circuit pattern, there occurs substantially no production of additional light component like this.

If depolarization occurs, because of coinciding planes of polarization, heterodyne interference is caused by the originally presented P-polarized P-polarized light component (frequency $\omega$) and the light component (frequency $\omega+\Delta\omega$) resulting from the depolarization. Similarly, because of coinciding planes of polarization, heterodyne interference is caused by the originally presented S-polarized S-polarized light component (frequency $\omega$) and the light component (frequency $\omega+\Delta\omega$) resulting from the depolarization. Where the polarization filter 42 disposed in front of the photodetector is one adapted to selectively transmit the P-polarized light only, the photoelectric detector 29 receives only the heterodyne interference light of P-polarized component, and a corresponding beat signal is produced. Where the polarization filter 42 is one adapted to selectively transmit the S-polarized light only, the detector 29 receives only the heterodyne interference light of S-polarized component, and a corresponding beat signal is produced.

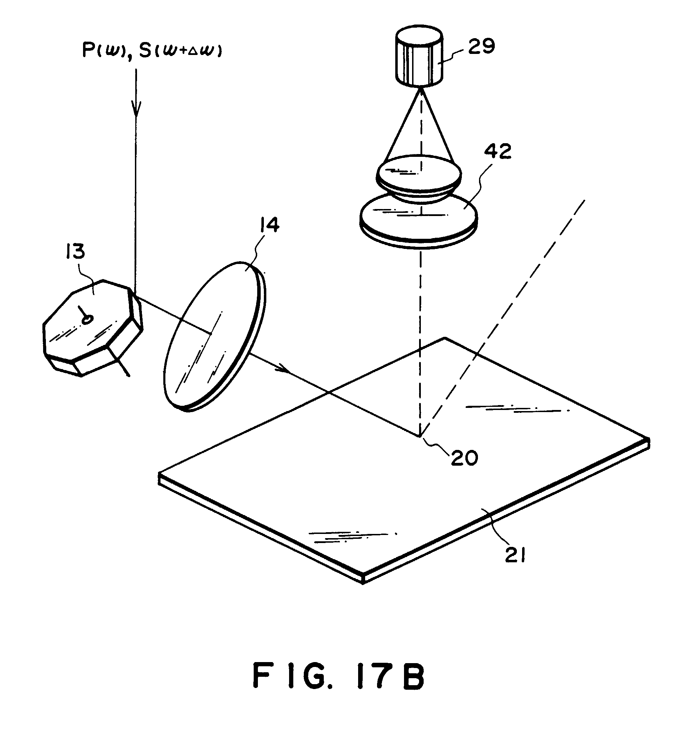

As described, by projecting a single light beam containing both the P-polarized component and the S-polarized component, having a frequency difference, to the surface to be inspected without separating them and thus in the form of a coaxial beam, and by detecting any scattered light therefrom by the detector 29 through the polarization filter 42 having a suitable polarization axis, it is possible to detect a beat signal corresponding to the depolarized scattered light from a particle or fault. It is seen therefrom that the positions of the polarization filter 42 and the photodetector 29 are not limited to receive the back scattered light, scattered toward the f-$\theta$ lens 14, such as shown in Figure 17A. They may be disposed so as to detect forward scattered light or sideward scattered light. Figure 17B shows an example arranged to detect back and sideward scattered light.

Next, the manner of distinguishing a particle or fault from a circuit pattern, will be explained in detail. Generally, the spot has a diameter of several ten microns, and a particle to be detected has a size not greater than one-tenth (1/10) of it. Thus, the time period in which the scattered light is produced is approximately equal to the time period in which the spot passes the particle. If, as an example, the scanning mirror 13 comprises an octahedral polygonal mirror rotating at 2000 rpm, the scanning spot 20 passes a particle 201 in several hundred seconds. Thus, if a driving frequency difference of 20 MHz is applied to the acousto-optic devices 9 and 11, then, in this period of several hundred seconds, frequency signals of about ten are superposed on a DC signal.

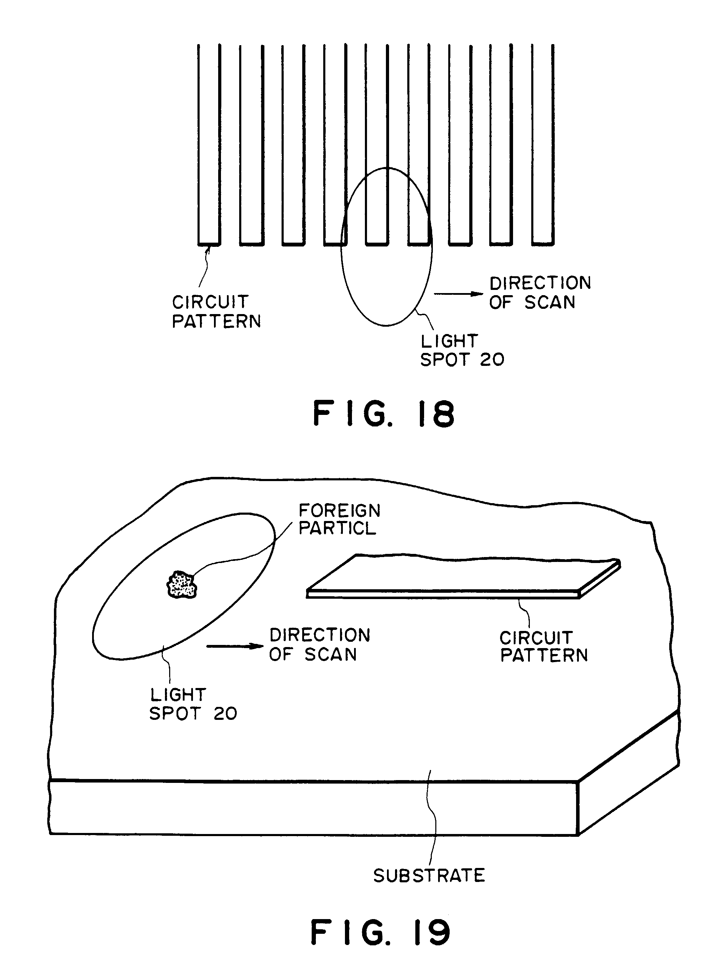

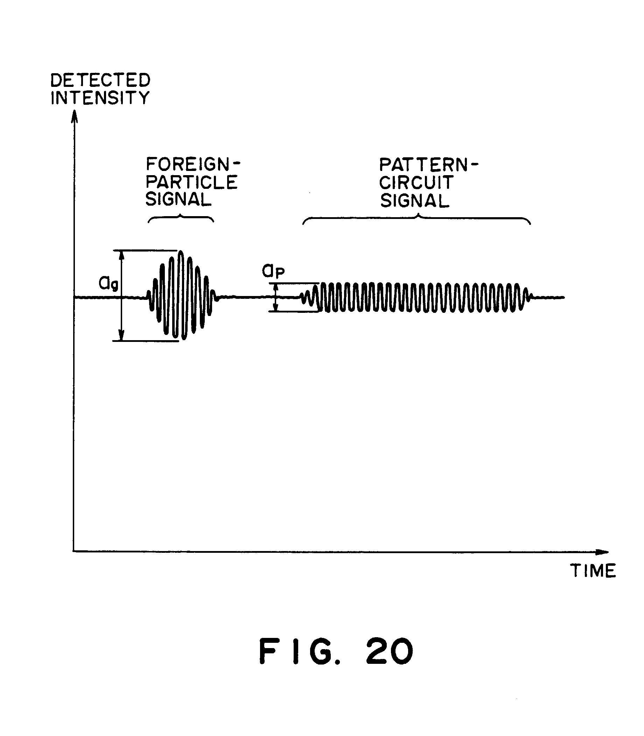

On the other hand, in many cases the circuit pattern comprises repeated pattern elements such as shown in Figure 18, and it is larger than the spot 20. If, as an example, both a particle and a circuit pattern are present in the scan region, a resultant detection signal from the photodetector 29 may be such as shown in Figure 20, for example. As described hereinbefore, since depolarization occurs in the light scattering by a particle or fault, a beat signal having a large amplitude is produced. On the other hand, in the light scattering by a circuit pattern, depolarization occurs substantially hardly. Thus, there is produced no beat signal, or only a very weak beat signal is produced. Consequently, the amplitude at a certain beat frequency is considerably larger in the case of a particle or fault (amplitude $a_p$) than in the case of a circuit pattern (amplitude $a_g$). Thus, based on this difference, it is possible to distinguish a particle or fault from a circuit pattern.

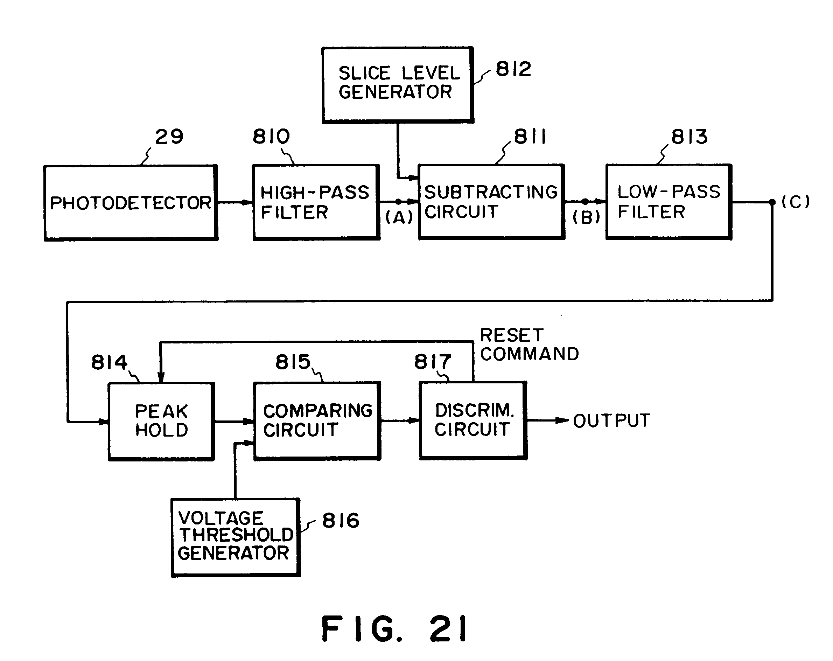

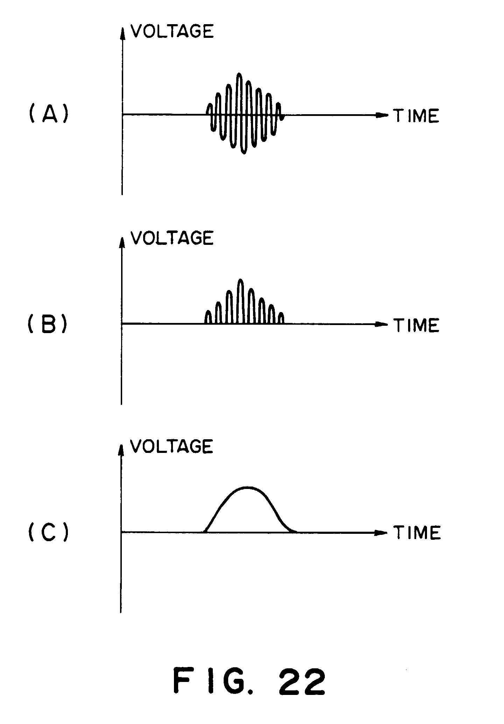

Figure 21 is a block diagram showing details of a signal processing circuit. Figure 22 shows signal waveforms at respective portions in Figure 21. Generally stating, the signal processing circuit comprises a block for converting a beat signal into an envelope, and a block for discriminating a particle or fault while distinguishing it from a circuit pattern on the basis of the level of the envelope.

The detection signal obtained through the photoelectric detector 29 is applied to a highpass filter 810 by which its DC components are removed (Figure 22, (A)). Subtracting circuit 811 subtracts a predetermined voltage, as applied by a slice level generating circuit 812, from the output voltage of the highpass filter 810, whereby those lower than a predetermined voltage are removed (Figure 22, (B)). Then, through a lowpass filter 813, it is shaped into an envelope of beat signal (Figure 22, (C)). This is the process of converting a beat signal into an envelope. The resultant envelope is applied to a peak-hold circuit 814 whereby the maximum signal level of it is held. Comparing circuit 815 compares in magnitude the peak-hold level and a voltage threshold level as applied from a threshold level generating circuit 816. On the basis of the result of this comparison, a discriminating circuit 817 discriminates a particle or fault while distinguishing it from a circuit pattern, and a corresponding signal is outputted. If the processing to one signal is completed, the discriminating circuit 817 applies a reset signal to the peak-hold circuit 814, for resetting the peak-hold level.

Embodiment 8

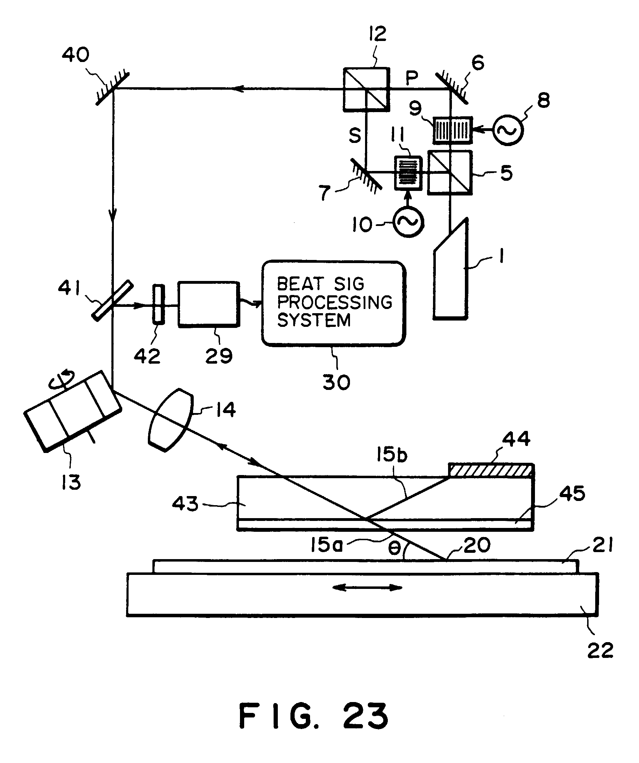

Figure 23 shows the structure of an eighth embodiment of the present invention. Like numerals as those of the Figure 17 embodiment are assigned to corresponding or similar elements. In the drawing, a polarization filter 42 is so disposed as to have its axis of transmission inclined by 45 deg. to both of the planes of polarization of P-polarized light and S-polarized light. Denoted at 43 is a transparent flat glass plate; at 44 is a scattering member formed on the glass plate 43; and at 45 is a polarization beam splitter provided at the bottom of the glass plate 43.

An important structural feature of this embodiment resides in that the flat glass plate 43, which has the scattering member 44 formed in a portion of the upper surface thereof and the polarization beam splitter 45 formed at its bottom, is disposed in front of the surface 21 to be inspected. The scattering member 44 has a structure effective to cause light scattering. It may comprise edges of patterns etched with chromium, like a circuit pattern. These edges may be formed along the scan line. The polarization beam splitter 45 has an optical property for transmitting P-polarized light components and reflecting S-polarized light components. By this polarization beam splitter 45, the scanning light from an f-$\theta$ lens 14 is separated into a P-polarized laser beam 15a (shift frequency $\omega$) and an S-polarized laser beam 15b (shift frequency $\omega+\Delta\omega$). The transmitted and separated P-polarized laser beam 15a is converged upon the surface 21 to be inspected to form a scanning spot thereon. On the other hand, the reflected and separated S-polarized laser beam 15b is converged on the edge portion of the scattering member 44 to scan the same.

If there is a particle or fault or a circuit pattern in an area scanned with the P-polarized laser beam 15a, scattered light is produced. On the other hand, scattered light is produced also by the S-polarized light 15b converged on the scattering member 44. Of these scattered lights, those components scattered along a path in the same direction as the path of light incidence go via the polarization beam splitter 45, the f-$\theta$ lens 14 and the scanning mirror 13 and impinge on a half mirror 41. Then, the P-polarized component and the S-polarized component reflected by the half mirror 41 are received by the polarization filter 42 by which the directions of polarization are aligned. As a consequence, due to optical heterodyne interference, there occurs beating of light intensity. This is photoelectrically converted by the photoelectric detector 29, whereby a beat signal is produced.

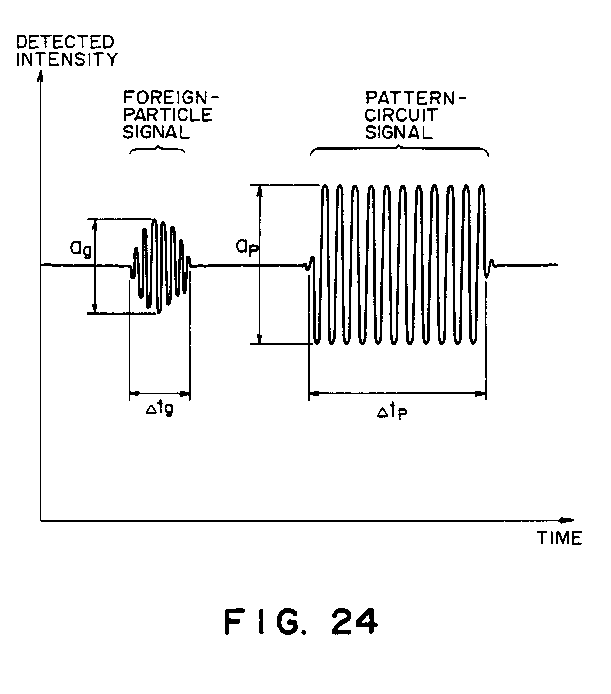

Now, the manner of distinguishing scattered light from a particle or fault, over scattered light from a circuit pattern, in this embodiment, will be explained. Figure 24 shows signal waveforms which may be obtained through the apparatus of this embodiment under the same condition as the Figure 19 example. Here, if the signal time width or period of a beat signal attributable to a particle is denoted by $\Delta$Tg while the signal time width or period attributable to a circuit pattern is denoted by $\Delta$Tp, then they are in the following relationship:

$$\Delta Tg < \Delta Tp$$

The present embodiment uses this time difference to discriminate a particle or fault from a circuit pattern. Practically, by counting the number of waves of the beat frequency, the time width is detected. Namely, while in the preceding embodiment a particle or fault is discriminated from a circuit pattern by utilizing depolarization attributable to the particle or fault, in the present embodiment they are distinguished on the basis of signal processing.

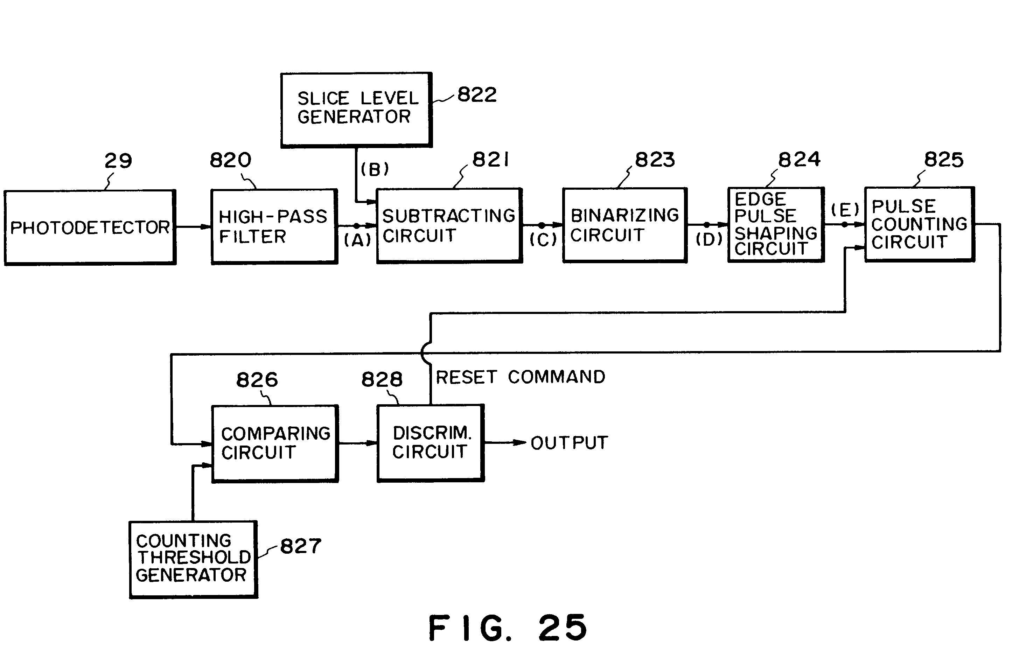

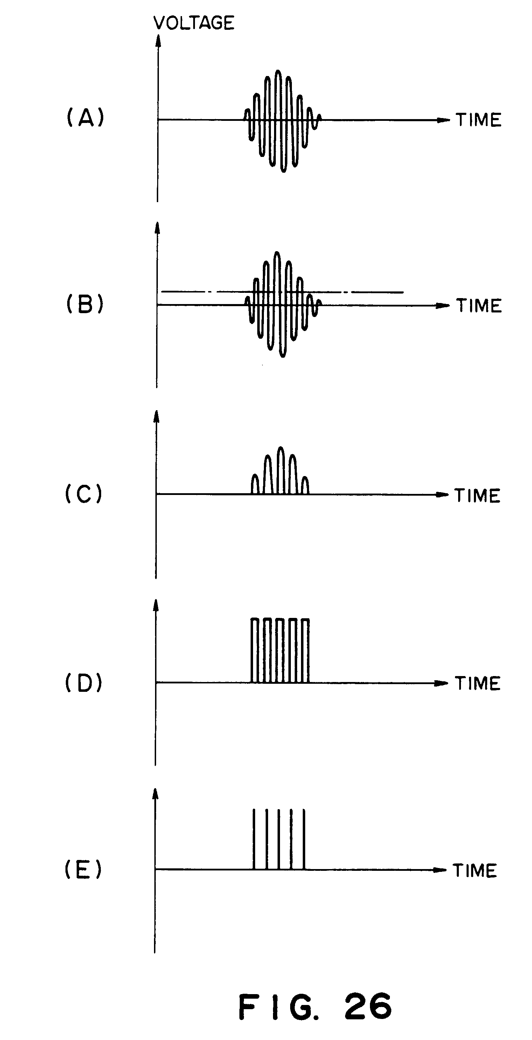

Figure 25 is a block diagram showing details of a signal processing circuit of this embodiment. Figure 26 shows signal waveforms at respective portions of Figure 25. Generally stating, the signal processing circuit comprises a block for converting a beat signal into pulses, and a block for discriminating a particle or fault while distinguishing it from a circuit pattern, on the basis of the number of the pulses.

The detection signal obtained through the photoelectric detector 29 is applied to a highpass filter 820 by which its DC components are removed (Figure 26, (A)). Subtracting circuit 821 subtracts a predetermined voltage (Figure 26, (B)), as applied by a slice level generating circuit 822, from the output voltage of the highpass filter 820, whereby those lower than a predetermined voltage are removed (Figure 26, (C)). Then, a binarizing circuit 823 shapes the signal into a rectangular wave (Figure 26, (D)). Edge pulse shaping circuit 824 then produces a pulse signal in response to each rise or fall in the rectangular wave (Figure 26, (E)). This is the process of converting a beat signal into pulses. The resultant pulse signals are counted by a pulse counting circuit 825, and a comparing circuit 826 compares in magnitude the number of counted pulses (representing the time width of the beat signal) with a threshold level as applied from a threshold level generating circuit 827. On the basis of the result of this comparison, a discriminating circuit 828 discriminates a particle or fault while distinguishing it from a circuit pattern, and a corresponding signal is outputted. If the processing to one signal is completed, the discriminating circuit 827 applies a reset signal to the pulse counting circuit 825, for resetting the pulse counting.

Embodiment 9

Next, an embodiment wherein the signal processing system of the preceding embodiment is improved, will be explained. In the embodiments described hereinbefore, if a particle or fault to be detected is extraordinarily small, the intensity of a signal obtainable from a photoelectric detector becomes very low and, thus, the time width in which a beat signal is produced become very short. In the present embodiment, in consideration of this, the signal processing system is modified so as to provide what may be called a "double heterodyne detection system", to assure good detection of even a very small particle or fault.

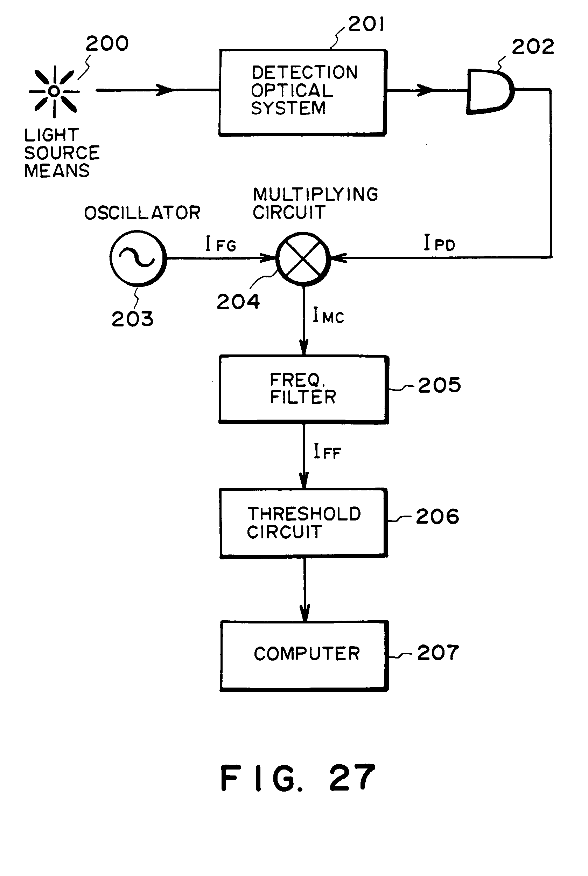

Details will now be explained. In the arrangement of Figure 27, a light source system 200 and a detection optical system 201 are of the same structure as of those of any one of the preceding embodiments, and optical heterodyne interference occurs in response to a particle or fault and thus a beat signal is produced by a photoelectric detector 202. Denoted at 203 is an oscillator; at 204 is a multiplying circuit; at 25 is a frequency filter; and 206 is a threshold circuit; and at 207 is a computer.

The higher the frequency of the beat signal detected by the photoelectric detector is, the better the result is. Since the frequency of the beat signal corresponds to the difference in frequency of two light beams which interfere (heterodyne interference) with each other, it is possible to make higher the frequency of the beat signal by providing a larger difference in frequency to them. Assuming now that two frequencies $f_1$ and $f_2$ constituting a beat signal has a difference of, e.g., $|f_1\text{-}f_2| = \Delta\omega/2\pi = 10$ GHz, then as described the electric fields $E_1$ and $E_2$ of the light emanating from the detection optical system 201 can be expressed as follows:

$$E_1 = A_1 \bullet \exp[j\{\omega t + \theta_1\}] \tag{11}$$

$$E_2 = A_2 \bullet \exp[j\{(\omega + \Delta\omega)t + \theta_2\}] \tag{12}$$

Here, the signal intensity $I_{PD}$ after the photoelectric conversion through the photoelectric detector 202 is expressed as follows:

$$I_{PD} = |E_1 + E_2|^2$$
$$= A_1^2 + A_2^2 + 2A_1 A_2 \cos(\Delta\omega t + \theta_2 - \theta_1) \tag{13}$$

From the third term of equation (13), it follows that the frequency of the beat signal is $\Delta\omega/2\pi = 10$GHz. If, therefore, the time width of pulse is about 200 ns., for example, about 2000 periods of 10 GHz beat signals are included in this pulse.

The oscillator 203 produces a sine wave of a frequency slightly different from $\Delta\omega/2\pi = 10$GHz, and here its frequency $f_{FG}$ is denoted as $f_{FG} = (\Delta\omega + \delta\omega)/2\pi = 10.1$ GHz. The beat signal detected by the photoelectric detector 202 and the signal from the oscillator 203 are applied to the multiplying circuit 204, and they are multiplied. Here, the intensity $I_{FG}$ of the signal from the oscillator 203 is:

$$I_{FG} = D_{FG} + A_{FG} \cos\{(\Delta\omega + \delta\omega) + \theta_{FG}\} \tag{14}$$

Assuming, for simplifying the coefficients of equation (13), that $A_1{}^2+A_2{}^2=D_{PD}$ and $2A_1A_2=A_{PD}$, then:

$$I_{PD} = D_{PD}+A_{PD}\bullet\cos(\Delta\omega t+\theta_2-\theta_1)$$

It follows that the signal $I_{MC}$ from the multiplying circuit is:

$$I_{MC} = D_{PD}\bullet D_{FG}$$

$$+ D_{PD}A_{FG}\bullet\cos\{(\Delta\omega+\delta\omega)t+\theta_{FG}\}$$

$$+ D_{FG}A_{PD}\bullet\cos(\Delta\omega t+\theta_2-\theta_1)$$

$$+ (A_{PD}A_{FG}/2)\bullet\cos(\delta\omega t+\theta_{FG}-\theta_2+\theta_1)$$

$$+ (A_{PD}A_{FG}/2)\bullet\cos\{(2\Delta\omega+\delta\omega)t+\theta_{FG}+\theta_2-\theta_1\} \qquad (15)$$

Since $\Delta\omega/2\pi = 10$ GHz and $f_{FG} = (\Delta\omega+\delta\omega)/2\pi = 10.1$ GHz, the frequency in each of the second and third terms of equation (15) is equal to about 10 GHz while that in the fifth term is equal to about 20 GHz. As compared, the frequency in the fourth term is $\delta\omega/2\pi = 100$ MHz. On the basis of the output signal from the multiplying circuit 204 as represented by equation (15) and by means of the frequency filter 205, the component of a frequency 100 MHz is extracted. This signal $I_{FF}$ can be expressed as:

$$I_{FF} = (A_{PD}A_{FG}/2)\bullet\cos(\delta\omega t+\theta_{FG}-\theta_2+\theta_1) \qquad (16)$$

This signal is applied to the threshold circuit 206 and is compared with a predetermined threshold level. If the signal is higher than the threshold level, it is discriminated that there is a particle or fault. This is counted by the computer 207. Since the amplitude of the signal from the frequency filter 205 is proportional to $A_{FG}$, as seen from equation (16), a further enhancement of the detection sensitivity is attainable by enlarging the amplitude of the oscillator 203.

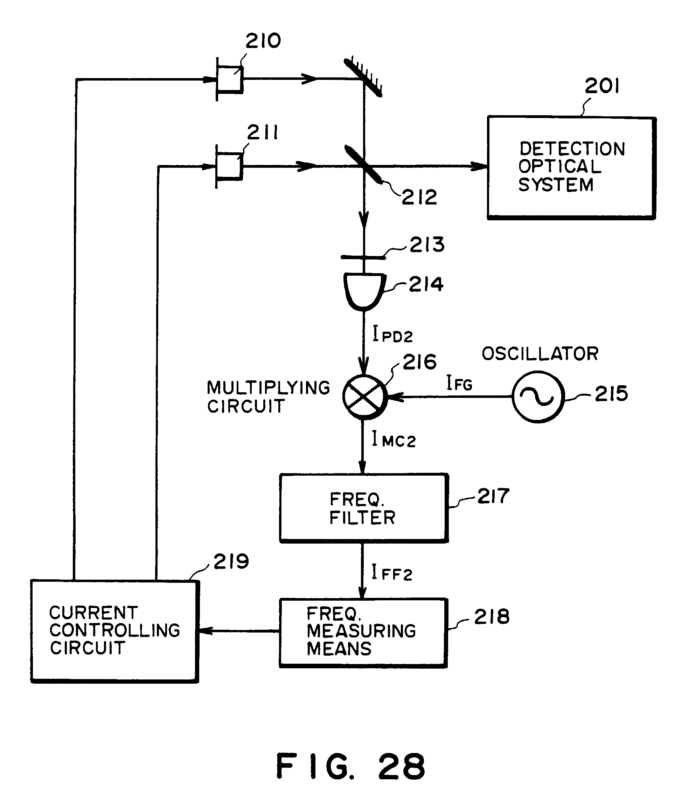

Figure 28 shows details of the light source system 200 of Figure 27. Denoted in the drawing at 210 and 211 are semiconductor lasers oscillating with mutually orthogonal planes of polarization, and they produces laser beams of slightly different frequencies $f_1$ and $f_2$. The lights from these two semiconductor lasers are combined by a half mirror 212 and advance in two directions. One of the lights is directed to the detection optical system as described, and it is used as a particle inspecting light. The other light is directed toward a photoelectric detector 214. Before the detector 214, there is provided a polarization filter 213 having its direction of polarization inclined by 45 deg. so as to cause heterodyne interference of the two frequency components.

Oscillator 215 produces a high-frequency electric signal $I_{FG}$ of a frequency 10.1 GHz, for example. The oscillator 203 of the aforementioned detection system may be used in common as the oscillator 215. The signal $I_{PD2}$ from the detector 214 and the electric signal $I_{FG}$ are applied to a multiplying circuit 216 and they are multiplied. The output signal from the multiplying circuit is applied to a frequency filter 217 which is adapted to selectively extract of a frequency component of about 100 MHz. The extracted signal $I_{FF2}$ is applied to a frequency measuring means 218. Current controlling circuit 219 first operates to inject a certain current $I_{LD1}$ into the laser 210. Then, by sweeping an injection current $I_{LD2}$ to the laser 211 with a level close to $L_{LD1}$, the signal $I_{FF2}$ can be applied to the frequency measuring means 218 only when the frequency difference between the signal $I_{PD2}$ from the detector 214 and the signal $I_{FG}$ from the oscillator 215 comes close to 100 MHz, that is, only when the beat signal $I_{PD2}$ is at 10.0 GHz or 10.2 GHz. The frequency measuring means 218 signals to the current controlling circuit 219 the detection of $I_{FF2}$, and the current controlling circuit 219 controls so as to maintain the injection current $I_{LD2}$ to the laser 211 substantially at that level. After this, the frequency measuring means 218 measures the frequency of $I_{FF2}$ and feedbacks any deviation from 100 MHz to the current controlling circuit 219 and, in accordance with this, the current controlling circuit 219 controls the injection current $I_{LD2}$ to the laser 211. With such feedback system, the beat frequency of a dual-frequency light source can be maintained at a constant and high level.

In this embodiment as described, an optical heterodyne signal and a signal from an oscillator adapted to provide a high-frequency electric signal, of a frequency slightly different from the heterodyne signal, are mutually multiplied by a multiplying circuit, and through a frequency filter a signal of desired frequency is extracted out of an output signal of the multiplying circuit. This enables setting the frequency of the optical heterodyne signal high. Namely, what may be called "double heterodyne detection" is executed. As a consequence, the number of periods of the optical heterodyne signal to be photoelectrically converted by the photoelectric detector when one particle or particulate is to be detected, increases. Also, the occurrence of the optical heterodyne interference can be discriminated more accurately. Further, with an increase in the amplitude of an electric signal, it is possible to enlarge the amplitude of a detection signal. This enables to provide a high detection signal from a weak optical heterodyne signal. Moreover, by means of a frequency filter adapted to selectively extract a particular frequency, it is possible to remove undesirable DC components of a detection signal. This provides assured detection. In summary, the present embodiment assures the following advantageous effects:

(1) Even with heterodyne interference of low intensity, an amplified detection signal is obtainable by enlarging the signal intensity from an oscillator. Thus, an increased detection sensitivity is assured.
(2) Because of the possibility of increasing the beat frequency, the occurrence of beating can be detected even if the a particle or the like to be detected is very small and the time period of beat signal production is very short.
(3) Through adjustment of the optical heterodyne frequency and the frequency of a signal from the oscillator, such a frequency being able to be easily extracted by the frequency filter can be set. Thus, a detection signal can be separated from DC components or noises efficiently, and an enhanced S/N ratio is assured.

Embodiment 10

Next, a tenth embodiment of the present invention will be explained. In the ninth embodiment described above, a high-frequency signal is generated by means of an electric oscillator, for "double heterodyne detection". In this embodiment, as compared, a similar high-frequency signal is generated optically, to execute similar "double heterodyne detection".

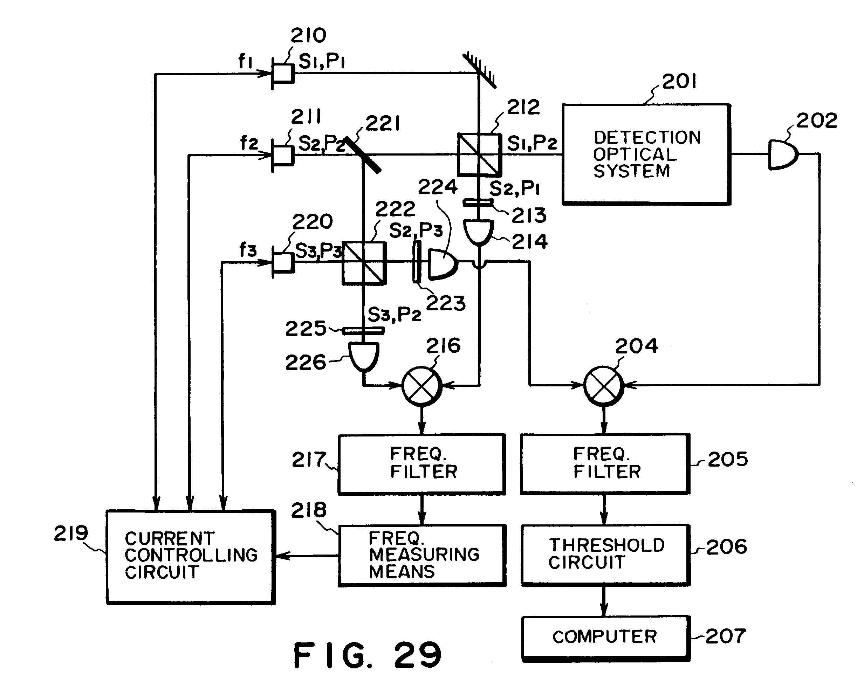

Figure 29 shows the structure of this embodiment, which is based on basically the same concept as of the ninth embodiment. Like numerals as those in Figures 27 and 28 are assigned to corresponding or similar elements. An important structural feature of this embodiment resides in the provision of a semiconductor laser 220, a half mirror 221, a polarization beam splitter 222, a polarization filter 223, a photoelectric detector 224, a polarization filter 225 and a photoelectric detector 226. These elements ensure a similar function as that of the electric oscillator of the ninth embodiment. The semiconductor laser 220 produces a laser beam of a frequency $f_3$ which is slightly different from the frequencies $f_1$ and $f_2$ of semiconductor lasers 210 and 211, respectively. While not shown in the drawing, a quarter phase difference plate is disposed adjacent to the exit portion of each semiconductor laser, so that each laser can provide a laser beam, transformed from linearly polarized light into circularly polarized light. In this embodiment, the semiconductor lasers 210 and 211 have a frequency difference of 10.0 GHz. Thus, a beat signal attributable to a particle of fault and obtainable with a photoelectric detector 202, is 10.0 GHz. Also, the semiconductor lasers 211 and 220 have a frequency difference of 10.1 GHz. Thus, through each of the photoelectric detectors 224 and 226, a beat signal of 10.1 GHz, namely, a signal similar to the high-frequency signal as obtainable through the oscillator of the ninth embodiment, is obtainable.

In this embodiment, one of the two light beams, more particularly, the light beam from the light source 211, is divided by the half mirror for production of a high-frequency signal. However, this may be replaced by use of an additional or fourth semiconductor laser.

Detection optical system 201 may have a similar structure as that of any one of the embodiments described hereinbefore. Heterodyne interference light obtained therein is detected by the photoelectric detector 202. An output (10.0 MHz) thereof as well as an output (10.1 MHz) of the photodetector 224, detecting the optically produced high-frequency signal, are mutually multiplied by a multiplying circuit 204, such that, through the heterodyne detection based on similar signal processing as in the Figure 27 example, a particle or fault can be detected with good precision. On the other hand, an output (10.0 MHz) of the photodetector 214 and an output (10.1 MHz) of the photoelectric detector 226 are mutually multiplied by a multiplying circuit 216 and, through similar signal processing as in the Figure 28 example, the frequency stabilization of the light source means is assured.

Embodiment 11

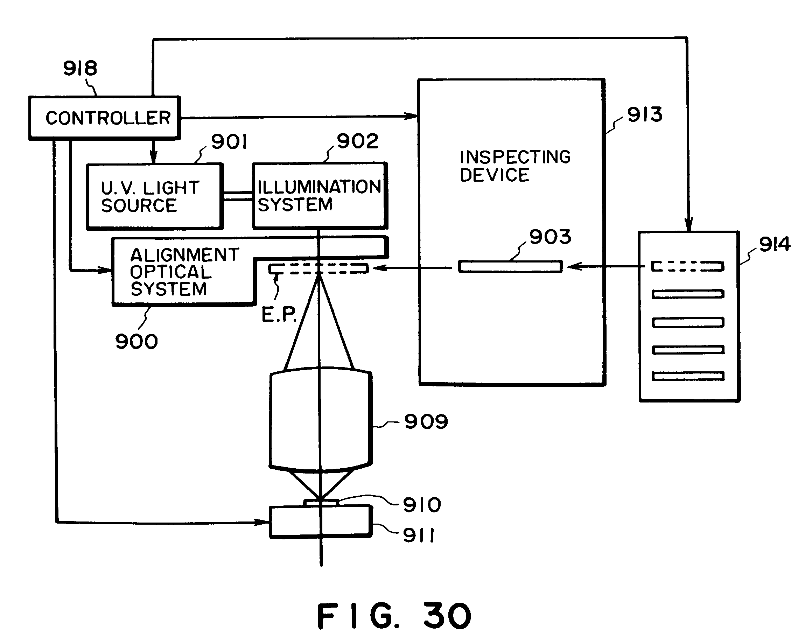

Figure 30 shows an embodiment of a semiconductor device manufacturing system for printing a circuit pattern of an original such as a reticle or photomask upon a silicon wafer. Generally stating, this system comprises an exposure apparatus, an original storing device, an original inspecting device and a controller, all being placed in a clean room.

Denoted at 901 is a deep ultraviolet light source such as an excimer laser, for example, and denoted at 902 is an illumination system unit for illuminating an original, held at an exposure position (E.P.), simultaneously (whole surface illumination) from the above and with a predetermined numerical aperture (NA). Denoted at 909 is an ultra-high-resolution lens system (or mirror system) for transferring the circuit pattern formed on the original onto a silicon wafer 910.

Upon printing, the wafer is shifted one-shot by one-shot with stepwise motion of a movable stage 911 so that repeated exposures are made thereto. Denoted at 900 is an alignment optical system for aligning the original and the wafer prior to the exposure operation. It includes at least one original observing microscope system. These elements constitute the exposure apparatus.

On the other hand, denoted at 914 is the original storing device for accommodating therein a plurality of originals. Denoted at 913 is the original inspecting device which has the structure according to any one of the preceding embodiments. The inspecting device 913 serves to execute particle inspection to a selected one of the originals, taken out of the storing device 914, before it is placed at the exposure station EP. The principle and manner of particle inspection is the same as that of the corresponding embodiment. Controller 918 serves to control the sequence of the while system and, as an example, it controls the operation of the storing device 914 and the inspecting device 913 as well as the alignment and exposure operation and wafer stepwise operation which are basic operations of the exposure apparatus.

A semiconductor device manufacturing process using the system of the present embodiment will now be explained. First, an original to be used is taken out of the original storing device 914 and it is placed in the inspecting device 913. Then, particle inspection to this original is executed through the inspecting device. If, as a result of inspection, it is discriminated that no particle is present on the original, the original is then placed at the exposure station EP in the exposure apparatus. Subsequently, a silicon wafer 910 which is an article to be exposed is placed on the movable stage 911. Then, while moving the movable stage 911 stepwise and shifting the wafer one-shot by one-shot in accordance with the step-and-repeat method, the pattern of the original is projected in a reduced scale on different zones of the silicon wafer to expose them. After the exposure process to one wafer is completed, this wafer is off-loaded and a new silicon wafer is loaded, and step-and-repeat exposures of it to the pattern of the original are repeated in the same manner.

The "exposed" wafer whose exposure process is completed, is subjected to a developing process, an etching process and so on through respective devices provided separately from the illustrated system. After this, it is subjected to assembling processes such as dicing, wire bonding, packaging and so on, whereby semiconductor devices are finished.

<u>Embodiment 12</u>

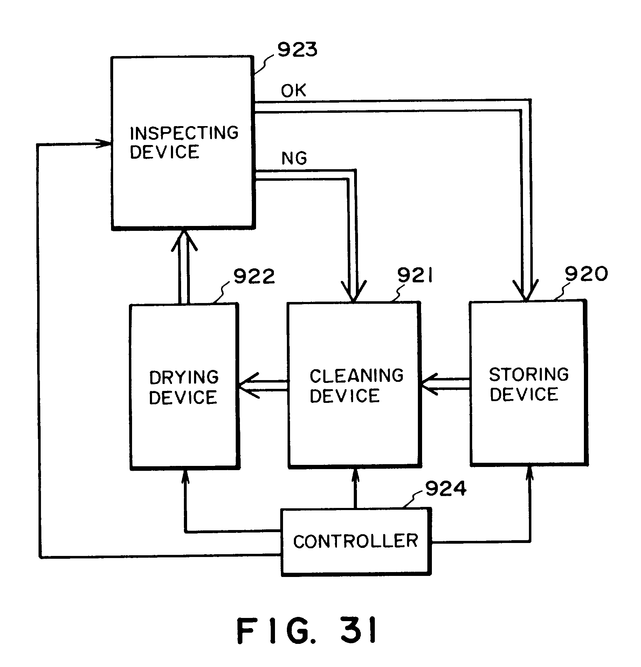

Figure 31 shows an embodiment of an original cleaning and inspecting system for manufacture of semiconductor devices. Generally stating, the system comprises an original storing device, a cleaning device, a drying device, an inspecting device and a controller, all being placed in a clean room.

The operation will be explained. First, an original to be cleaned is taken out of the original storing device 920 and it is moved into the cleaning device 921. After the cleaning in the cleaning device 921, the cleaned original is moved into the drying device 922 and is dried. After it is dried, it is moved into the inspecting device 923. In this inspecting device, any foreign particle on this original is inspected in accordance with the method of any one of the embodiments described hereinbefore. If as a result of inspection any particle is not detected, the original is moved back into the storing device 920. If any particle is detected, the original is moved back to the cleaning device 921 and, after repetition of the cleaning and drying operation, it is inspected again. This is repeated until particles are totally removed, and a completely cleaned original is moved back into the storing device 920.

Subsequently, such a cleaned original is placed in an exposure apparatus and the printing of a circuit pattern of the original on a silicon wafer is executed, for manufacture of semiconductor devices.

While the invention has been described with reference to the structures disclosed herein, it is not confined to the details set forth and this application is intended to cover such modifications or changes as may come within the purposes of the improvements or the scope of the following claims.

**Claims**

1. An inspection apparatus, comprising:

light producing means (1,2,3,4,5,6,8,9,10,11) for producing (i) a first light beam (S) having a first wavelength and (ii) a second light beam (P) having a second wavelength, different from the first wavelength;
light projecting means (13,14,15,16,17,18,19) for projecting at least the first light beam (S) to a position (20) of inspection;
detecting means (27,29) for detecting heterodyne interference light produced on the basis of the second light beam (P) and the light scattered at said position; and
signal processing means (30) for processing the detected interference light to determine the state at said position of inspection;

characterised in that

said light producing means (1,2,3,4,5,6,8,9,10,11) produces the first light beam (S) having a first state of polarization and the second light beam (P) having a second state of polarization different from the first polarization, and said detecting means (27,29) is adapted to detect heterodyne interference light produced on the basis of the second light beam and the light scattered at said position (20) and having its state of polarization changed by the scattering from the first state of polarization.

2. An apparatus according to claim 1, wherein said light projecting means (13,14,15,16,17,18,19) includes scanning means (13) for relatively scanning a surface to be inspected with the first light beam (S).

3. An apparatus according to claim 2, wherein said scanning means (13) comprises means for moving the first light beam (S).

4. An apparatus according to claim 3, wherein said scanning means (13) comprises a rotatable mirror for scanningly deflecting the first light beam (S).

5. An apparatus according to claim 1, further comprising a lens system (26) for imaging a scan region on said surface upon a detection surface of said detecting means (29).

6. An apparatus according to claim 1, wherein said light projection means (13,14,15,16,17,18,19) is arranged to project the second light beam (P) on the same position being irradiated with the first light beam (S).

7. An apparatus according to claim 6, wherein said light projection means (13,14,15,16,17,18,19) is arranged to project the second light beam (P) on the same position (20) being irradiated with the first light beam (S), in a direction different from the direction of projection of the first light beam (S), to cause heterodyne interference of zero-th order diffraction light of the second light beam (P) and scattered light of the first light beam (S).

8. An apparatus according to claim 1, wherein said projection means is arranged to project the first light beam (S) and the second light beam (P) as a single light beam onto the same position (20).

9. An apparatus according to claim 8, wherein the second light beam and the light scattered in response to the projection of the first light beam upon said position to be inspected and scattered in a direction along the path of projection of the first light beam upon said position, are caused to produce heterodyne interference.

10. An apparatus according to claim 1, wherein said projection means is arranged not to project the second light beam to said position and wherein the second light beam and the scattered light attributable to the first light beam are caused to produce heterodyne interference.

11. An apparatus according to claim 10, wherein the second light beam and the light scattered in response to the projection of the first light beam upon said position to be inspected and scattered in a direction along the path of projection of the first light beam upon said position, are caused to produce heterodyne interference.

12. An apparatus according to claim 1, wherein said light producing means produces a single light beam in which the first and second light beams are superposed one another.

13. An apparatus according to claim 1, wherein said light producing means produces the first and second light beams separately.

14. An apparatus according to claim 1, wherein said light producing means is arranged to produce the first light beam having the first state of polarization which is linear polarization in a predetermined direction and the second light beam having the second state of polarization which is linear polarization in a direction perpendicular to said predetermined direction.

15. An apparatus according to claim 1, wherein said light producing means is arranged to produce the first light beam having the first state of polarization which is circular polarization in a predetermined rotational direction and the second light beam having the second state of polarization which is circular polarization in a rotational direction countering to said predetermined rotational direction.

16. An apparatus according to claim 1, wherein said signal processing means (30) includes means for counting waves of the beat signal.

17. An apparatus according to claim 1, further comprising oscillating means for generating a high-frequency signal of a frequency different from that of the beat signal of the detected interference light, and multiplying means for mutually multiplying the high-frequency signal and the beat signal, and wherein the state of said position being inspected is determined on the basis of the result of multiplication.

18. An apparatus according to claim 1, wherein said light producing means includes a laser light source.

19. An apparatus according to claim 1, further comprising (i) second light producing means for producing a third light beam having a third state of polarization and a third wavelength, and a fourth light beam having a fourth state of polarization, different from the third state of polarization, and a fourth wavelength different from the third wavelength, (ii) second light projecting means for projecting at least the third light beam to a position of inspection, and (iii) second detecting means for detecting heterodyne interference light produced on the basis of the fourth light beam and the light scattered at said position as a result of projection of the third light beam, wherein said signal processing means serves to detect the state at said position on the basis of beat signals of the detected interference lights, detected by said first and second detecting means.

20. An apparatus according to claim 19, wherein said second projecting means includes scanning means for relatively scanning a surface to be inspected with the third light beam.

21. An apparatus according to claim 19, further comprising oscillating means for generating a high-frequency signal of a frequency different from that of the beat signal of the detected interference light, and multiplying means for mutually multiplying the high-frequency signal and the beat signal, and wherein the state of said position being inspected is determined on the basis of the result of multiplication.

22. An apparatus according to claim 1, further comprising (i) second detecting means for detecting heterodyne interference light produced on the basis of the second light beam and the light scattered from said position in a direction, different from that of said detecting means, as a result of projection of the first light beam, wherein said signal processing means serves to inspect the state at said position on the basis of beat signals of the detected interference lights, detected by said first and second detecting means.

23. An apparatus according to claim 22, further comprising oscillating means for generating a high-frequency signal of a frequency different from that of the beat signal of the detected interference light, and multiplying means for mutually multiplying the high-frequency signal and the beat signal, and wherein the state of said position being inspected is determined on the basis of the result of multiplication.

24. An apparatus according to claim 1, wherein said detecting means includes oscillating means for generating a high-frequency signal of a frequency different from that of the beat signal of the detected interference light, and multiplying means for mutually multiplying the high-frequency signal and the beat signal, said inspecting means inspecting the state of said position on the basis of the result of multiplication.

25. An apparatus according to claim 24, wherein said oscillating means includes means for generating the high-frequency signal electrically.

26. An apparatus according to claim 24, wherein said oscillating means includes means for generating the high-frequency signal optically.

27. An exposure apparatus having an inspection apparatus as recited in any one of claims 1 to 26

28. A cleaning and inspecting system having an inspection apparatus as recited in any one of claims 1 to 26.

29. A device manufacturing system having an inspection apparatus as recited in any one of claims 1 to 26.

30. A device manufacturing method comprising the steps of inspecting a device pattern of a mask using the inspection apparatus as recited in any one of claims 1 to 26, transferring onto a workpiece the device pattern of a mask, and forming a device from the patterned workpiece.

**Patentansprüche**

1. Inspizierungsgerät mit folgendem:

   einer Lichterzeugungseinrichtung (1, 2, 3, 4, 5, 6, 8, 9, 10, 11) zum Erzeugen von (i) einem ersten Lichtstrahl (S) mit einer ersten Wellenlänge und (ii) einem zweiten Lichtstrahl (P) mit einer zweiten Wellenlänge, die sich von der ersten Wellenlänge unterscheidet;
   einer Lichtprojektionseinrichtung (13, 14, 15, 16, 17, 18, 19) zum Projizieren zumindest des ersten Lichtstrahls (S) auf eine Position (20) der Inspizierung;
   einer Erfassungseinrichtung (27, 29) zum Erfassen eines Überlagerungsinterferenzlichts, das auf der Grundlage des zweiten Lichtstrahls (P) und des an der Position gestreuten Lichts erzeugt wird; und
   einer Signalverarbeitungseinrichtung (30) zum Verarbeiten des erfaßten Interferenzlichts, um den Zustand an der Position der Inspizierung zu bestimmen;

   dadurch gekennzeichnet, daß

   die Lichterzeugungseinrichtung (1, 2, 3, 4, 5, 6, 8, 9, 10, 11) den ersten Lichtstrahl (S) mit einem ersten Zustand einer Polarisation und den zweiten Lichtstrahl (P) mit einem zweiten Zustand einer Polarisation erzeugt, die sich von der ersten Polarisation unterscheidet, wobei die Erfassungseinrichtung (27, 29) dazu angepaßt ist, ein Überlagerungsinterferenzlicht zu erfassen, das auf der Grundlage des zweiten Lichtstrahls und des an der Position (20) gestreuten Lichts erzeugt wird, der seinen Zustand der Polarisation durch das Streuen gegenüber dem ersten Zustand der Polarisation geändert hat.

2. Gerät nach Anspruch 1, wobei die Lichtprojektionseinrichtung (13, 14, 15, 16, 17, 18, 19) eine Abtasteinrichtung (13) zum relativen Abtasten einer zu inspizierende Oberfläche mit dem ersten Lichtstrahl (S) umfaßt.

3. Gerät nach Anspruch 2, wobei die Abtasteinrichtung (13) eine Einrichtung zum Bewegen des ersten Lichtstrahls (S) aufweist.

4. Gerät nach Anspruch 3, wobei die Abtasteinrichtung (13) einen drehbaren Spiegel zum abtastenden Ablenken des ersten Lichtstrahls (S) aufweist.

5. Gerät nach Anspruch 1, das des weiteren ein Linsensystem (26) zum Abbilden eines Abtastbereichs auf der Oberfläche auf eine Erfassungsoberfläche der Erfassungseinrichtung (29) aufweist.

6. Gerät nach Anspruch 1, wobei die Lichtprojektionseinrichtung (13, 14, 15, 16, 17, 18, 19) dazu angeordnet ist, den zweiten Lichtstrahl (P) auf die selbe Position zu projizieren, die mit dem ersten Lichtstrahl (S) bestrahlt wird.

7. Gerät nach Anspruch 6, wobei die Lichtprojektionseinrichtung (13, 14, 15, 16, 17, 18, 19) dazu angeordnet ist, den zweiten Lichtstrahl (P) auf die selbe Position (20), die mit dem ersten Lichtstrahl (S) bestrahlt wird, in einer Richtung zu projizieren, die sich von der Richtung einer Projektion des ersten Lichtstrahls (S) unterscheidet, um eine Überlagerungsinterferenz von Beugungslicht nullter Ordnung des zweiten Lichtstrahls (P) und des gestreuten Lichts des ersten Lichtstrahls (S) hervorzurufen.

8. Gerät nach Anspruch 1, wobei die Projektionseinrichtung dazu angeordnet ist, den ersten Lichtstrahl (S) und den zweiten Lichtstrahl (P) als einen einzigen Lichtstrahl auf die selbe Position (20) zu projizieren.

9. Gerät nach Anspruch 8, wobei der zweite Lichtstrahl und das Licht, das ansprechend auf die Projektion des ersten Lichtstrahls auf die zu inspizierende Position gestreut wird und das in einer Richtung entlang der Bahn der Projektion des ersten Lichtstrahls auf die Position gestreut wird, dazu gebracht werden, eine Überlagerungsinterferenz zu erzeugen.

10. Gerät nach Anspruch 1, wobei die Projektionseinrichtung dazu angeordnet ist, den zweiten Lichtstrahl nicht auf die Position zu projizieren, und wobei der zweite Lichtstrahl und das dem ersten Lichtstrahl zurechenbare gestreute Licht dazu gebracht werden, eine Überlagerungsinterferenz zu erzeugen.

11. Gerät nach Anspruch 10, wobei der zweite Lichtstrahl und das Licht, das ansprechend auf die Projektion des ersten Lichtstrahls auf die zu inspizierende Position gestreut wird und das in einer Richtung entlang der Bahn einer Projektion des ersten Lichtstrahls auf die Position gestreut wird, dazu gebracht werden, eine Überlagerungsinterferenz zu erzeugen.

12. Gerät nach Anspruch 1, wobei die Lichterzeugungseinrichtung einen einzigen Lichtstrahl erzeugt, in dem der erste und zweite Lichtstrahl miteinander überlagert werden.

13. Gerät nach Anspruch 1, wobei die Lichterzeugungseinrichtung den ersten und zweiten Lichtstrahl getrennt voneinander erzeugt.

14. Gerät nach Anspruch 1, wobei die Lichterzeugungseinrichtung dazu angeordnet ist, den ersten Lichtstrahl mit dem ersten Zustand der Polarisation, der eine lineare Polarisation in einer vorbestimmten Richtung ist, und den zweiten Lichtstrahl mit einem zweiten Zustand der Polarisation zu erzeugen, der eine lineare Polarisation in einer zur vorbestimmten Richtung senkrechten Richtung ist.

15. Gerät nach Anspruch 1, wobei die Lichterzeugungseinrichtung dazu angeordnet ist, den ersten Lichtstrahl mit dem ersten Zustand der Polarisation, der eine zirkulare Polarisation in einer vorbestimmten Drehrichtung ist, und den zweiten Lichtstrahl mit einem zweiten Zustand der Polarisation zu erzeugen, der eine zirkulare Polarisation in einer Drehrichtung ist, die der vorbestimmten Drehrichtung entgegengesetzt ist.

16. Gerät nach Anspruch 1, wobei die Signalverarbeitungseinrichtung (30) eine Einrichtung zum Zählen von Wellen des Überlagerungssignals umfaßt.

17. Gerät nach Anspruch 1, das des weiteren eine Schwingungserzeugungseinrichtung zum Erzeugen eines Hochfrequenzsignals mit einer Frequenz, die sich von der des Überlagerungssignals des erfaßten Interferenzlichts unterscheidet, und eine Vervielfachungseinrichtung zum wechselseitigen Multiplizieren des Hochfrequenzsignals und des Überlagerungssignals aufweist, und wobei der Zustand der zu inspizieren Position auf der Grundlage des Ergebnisses der Multiplikation bestimmt wird.

18. Gerät nach Anspruch 1, wobei die Lichterzeugungseinrichtung eine Laserlichtquelle umfaßt.

19. Gerät nach Anspruch 1, das des weiteren (i) eine zweite Lichterzeugungseinrichtung zum Erzeugen eines dritten Lichtstrahls mit einem dritten zustand einer Polarisation und mit einer dritten Wellenlänge und eines vierten Lichtstrahls mit einem vierten Zustand einer Polarisation, der sich von dem dritten Zustand der Polarisation unterscheidet, und mit einer vierten Längenwelle, die sich von der dritten Wellenlänge unterscheidet, (ii) eine zweite Lichtprojektionseinrichtung zum Projizieren zumindest des dritten Lichtstrahls auf eine Position der Inspizierung und (iii) eine zweite Erfassungseinrichtung zum Erfassen eines Überlagerungsinterferenzlichts aufweist, das auf der Grundlage des vierten Lichtstrahls und des an der Position gestreuten Lichts als ein Ergebnis einer Projektion des dritten Lichtstrahls erzeugt wird, wobei die Signalverarbeitungseinrichtung dazu dient, den Zustand an der Position auf der Grundlage von Überlagerungssignalen der erfaßten Interferenzlichtstrahlen zu erfassen, die durch die erste und zweite Erfassungseinrichtung erfaßt werden.

20. Gerät nach Anspruch 19, wobei die zweite Projektionseinrichtung eine Abtasteinrichtung zum relativen Abtasten einer zu inspizierenden Oberfläche mit dem dritten Lichtstrahl umfaßt.

21. Gerät nach Anspruch 19, das des weiteren eine Schwingungserzeugungseinrichtung zum Erzeugen eines Hochfrequenzsignals mit einer Frequenz, die sich von der des Überlagerungssignals des erfaßten Interferenzlichts unterscheidet, und eine Vervielfachungseinrichtung zum wechselseitigen Multiplizieren des Hochfrequenzsignals und des Überlagerungssignals umfaßt, und wobei der Zustand der zu inspizierenden Position auf der Grundlage des Ergebnisses der Multiplikation bestimmt wird.

22. Gerät nach Anspruch 1, das des weiteren (i) eine zweite Erfassungseinrichtung zum Erfassen eines Überlagerungsinterferenzlichts aufweist, das auf der Grundlage des zweiten Lichtstrahls und des Lichts erzeugt wird, das von der Position in einer Richtung, die sich von der der Erfassungseinrichtung unterscheidet, als ein Ergebnis einer Projektion des ersten Lichtstrahls gestreut wird, wobei die Signalverarbeitungseinrichtung dazu dient, den Zustand an der Position auf der Grundlage von Überlagerungssignalen der erfaßten Interferenzlichtstrahlen zu inspizieren, die durch die erste und zweite Erfassungseinrichtung erfaßt werden.

23. Gerät nach Anspruch 22, das des weiteren eine Schwingungserzeugungseinrichtung zum Erzeugen eines Hoch-

**EP 0 567 701 B1**

frequenzsignals mit einer Frequenz, die sich von der des Überlagerungssignals des erfaßten Interferenzlichts unterscheidet, und eine Vervielfachungseinrichtung zum wechselseitigen Multiplizieren des Hochfrequenzsignals und des Überlagerungssignals aufweist, und wobei der Zustand der zu inspizierenden Position auf der Grundlage des Ergebnisses der Multiplikation bestimmt wird.

24. Gerät nach Anspruch 1, wobei die Erfassungseinrichtung eine Schwingungserzeugungseinrichtung zum Erzeugen eines Hochfrequenzsignals mit einer Frequenz, die sich von der des Überlagerungssignals des erfaßten Interferenzlichts unterscheidet, und eine Vervielfachungseinrichtung zum wechselseitigen Multiplizieren des Hochfrequenzsignals und des Überlagerungssignals umfaßt, wobei die Inspizierungseinrichtung den zustand der Position auf der Grundlage des Ergebnisses der Multiplikation inspiziert.

25. Gerät nach Anspruch 24, wobei die Schwingungserzeugungseinrichtung eine Einrichtung zum elektrischen Erzeugen des Hochfrequenzsignals umfaßt.

26. Gerät nach Anspruch 24, wobei die Schwingungserzeugungseinrichtung eine Einrichtung zum optischen Erzeugen des Hochfrequenzsignals umfaßt.

27. Belichtungsgerät mit einem Inspizierungsgerät nach einem der Ansprüche 1 bis 26.

28. Reinigungs- und Inspizierungssystem mit einem Inspizierungsgerät nach einem der Ansprüche 1 bis 26.

29. Vorrichtungsherstellungssystem mit einem Inspizierungsgerät nach einem der Ansprüche 1 bis 26.

30. Vorrichtungsherstellungsverfahren mit den Schritten, Inspizieren eines Vorrichtungsmusters einer Maske unter Verwendung des Inspizierungsgeräts nach einem der Ansprüche 1 bis 26, Übertragen des Vorrichtungsmusters einer Maske auf ein Werkstück und Ausbilden einer Vorrichtung aus dem gemusterten Werkstück.

**Revendications**

1. Appareil d'inspection, comportant :

   des moyens (1,2,3,4,5,6,8,9,10,11) de production de lumière destinés à produire (i) un premier faisceau lumineux (S) ayant une première longueur d'onde et (ii) un second faisceau lumineux (P) ayant une seconde longueur d'onde différente de la première longueur d'onde ;
   des moyens (13,14,15,16,17,18,19) de projection de lumière destinés à projeter au moins le premier faisceau lumineux (S) sur une position (20) d'inspection ;
   des moyens (27,29) de détection destinés à détecter une lumière d'interférence hétérodyne produite sur la base du second faisceau lumineux (P) et de la lumière diffusée dans ladite position ; et
   des moyens (30) de traitement de signaux destinés à traiter la lumière d'interférence détectée pour déterminer l'état dans ladite position d'inspection ;

   caractérisé en ce que

   lesdits moyens (1,2,3,4,5,6,8,9,10,11) de production de lumière produisent le premier faisceau lumineux (S) ayant un premier état de polarisation et le second faisceau lumineux (P) ayant un second état de polarisation différent de la première polarisation, et lesdits moyens de détection (27,29) sont conçus pour détecter une lumière d'interférence hétérodyne produite sur la base du second faisceau lumineux et de la lumière diffusée dans ladite position (20) et ayant son état de polarisation modifié par la diffusion à partir du premier état de polarisation.

2. Appareil selon la revendication 1, dans lequel lesdits moyens (13,14,15,16,17,18,19) de projection de lumière comprennent des moyens de balayage (13) destinés à réaliser un balayage relatif d'une surface devant être inspectée à l'aide du premier faisceau lumineux (S).

3. Appareil selon la revendication 2, dans lequel lesdits moyens de balayage (13) comprennent des moyens destinés à déplacer le premier faisceau lumineux (S).

4. Appareil selon la revendication 3, dans lequel lesdits moyens de balayage (13) comprennent un miroir tournant destiné à dévier en balayage le premier faisceau lumineux (S).

5. Appareil selon la revendication 1, comportant en outre un système de lentille (26) destiné à former une image d'une région de balayage sur ladite surface sur une surface de détection desdits moyens de détection (29).

6. Appareil selon la revendication 1, dans lequel lesdits moyens (13,14,15,16,17,18,19) de projection de lumière sont agencés de façon à projeter le second faisceau lumineux (P) sur la même position que celle irradiée par le premier faisceau lumineux (S).

7. Appareil selon la revendication 6, dans lequel lesdits moyens (13,14,15,16,17,18,19) de projection de lumière sont agencés de façon à projeter le second faisceau lumineux (P) sur la même position que celle irradiée par le premier faisceau lumineux (S), dans une direction différente de la direction de projection du premier faisceau lumineux (S), pour provoquer une interférence hétérodyne de la lumière de diffraction d'ordre zéro du second faisceau lumineux (P) et de la lumière diffusée du premier faisceau lumineux (S).

8. Appareil selon la revendication 1, dans lequel lesdits moyens de projection sont agencés pour projeter le premier faisceau lumineux (S) et le second faisceau lumineux (P) sous la forme d'un faisceau lumineux unique sur la même position (20).

9. Appareil selon la revendication 8, dans lequel le second faisceau lumineux est la lumière diffusée en réponse à la projection du premier faisceau lumineux sur ladite position devant être inspectée et diffusée dans une direction suivant le trajet de la projection du premier faisceau lumineux sur ladite position sont amenés à produire une interférence hétérodyne.

10. Appareil selon la revendication 1, dans lequel lesdits moyens de projection sont agencés de façon à ne pas projeter le second faisceau lumineux sur ladite position, et dans lequel le second faisceau lumineux et la lumière diffusée pouvant être attribués au premier faisceau lumineux sont amenés à produire une interférence hétérodyne.

11. Appareil selon la revendication 10, dans lequel le second faisceau lumineux et la lumière diffusée en réponse à la projection du premier faisceau lumineux sur ladite position devant être inspectée et diffusée dans une direction suivant le trajet de projection du premier faisceau lumineux sur ladite position, sont amenés à produire une interférence hétérodyne.

12. Appareil selon la revendication 1, dans lequel lesdits moyens de production de lumière produisent un faisceau lumineux unique dans lequel les premier et second faisceaux lumineux sont superposés.

13. Appareil selon la revendication 1, dans lequel lesdits moyens de production de lumière produisent les premier et second faisceaux lumineux séparément.

14. Appareil selon la revendication 1, dans lequel lesdits moyens de production de lumière sont agencés pour produire le premier faisceau lumineux ayant le premier état de polarisation qui est une polarisation linéaire dans une direction prédéterminée et le second faisceau lumineux ayant le second état de polarisation qui est une polarisation linéaire dans une direction perpendiculaire à ladite direction prédéterminée.

15. Appareil selon la revendication 1, dans lequel lesdits moyens de production de lumière sont agencés pour produire le premier faisceau lumineux ayant le premier état de polarisation qui est une polarisation circulaire dans un sens de rotation prédéterminé et le second faisceau lumineux ayant le second état de polarisation qui est une polarisation circulaire dans un sens de rotation opposé audit sens de rotation prédéterminé.

16. Appareil selon la revendication 1, dans lequel lesdits moyens (30) de traitement de signaux comprennent des moyens destinés à compter des ondes du signal de battement.

17. Appareil selon la revendication 1, comportant en outre des moyens oscillants destinés à générer un signal à haute fréquence, d'une fréquence différente de celle du signal de battement de la lumière d'interférence détectée, et des moyens de multiplication destinés à multiplier mutuellement le signal à haute fréquence et le signal de battement, et dans lequel l'état de ladite position inspectée est déterminé sur la base du résultat de la multiplication.

18. Appareil selon la revendication 1, dans lequel lesdits moyens de production de lumière comprennent une source de lumière laser.

19. Appareil selon la revendication 1, comportant en outre (i) des seconds moyens de production de lumière destinés à produire un troisième faisceau lumineux ayant un troisième état de polarisation et une troisième longueur d'onde, et un quatrième faisceau lumineux ayant un quatrième état de polarisation, différent du troisième état de polarisation, et une quatrième longueur d'onde différente de la troisième longueur d'onde, (ii) des seconds moyens de production de lumière destinés à projeter au moins le troisième faisceau lumineux sur une position d'inspection, et (iii) des seconds moyens de détection destinés à détecter une lumière d'interférence hétérodyne produite sur la base du quatrième faisceau lumineux et de la lumière diffusée dans ladite position à la suite d'une projection du troisième faisceau lumineux, et dans lequel lesdits moyens de traitement de signaux servent à détecter l'état dans ladite position sur la base de signaux de battement des lumières d'interférence détectées, détectées par lesdits premiers et seconds moyens de détection.

20. Appareil selon la revendication 19, dans lequel lesdits seconds moyens de projection comprennent des moyens de balayage destinés à réaliser un balayage relatif d'une surface devant être inspectée avec le troisième faisceau lumineux.

21. Appareil selon la revendication 19, comportant en outre des moyens oscillants destinés à générer un signal à haute fréquence d'une fréquence différente de celle du signal de battement de la lumière d'interférence détectée, et des moyens de multiplication destinés à multiplier mutuellement le signal à haute fréquence ou le signal de battement, et dans lequel l'état de ladite position inspectée est déterminé sur la base du résultat de la multiplication.

22. Appareil selon la revendication 1, comportant en outre (i) des seconds moyens de détection destinés à détecter une lumière d'interférence hétérodyne produite sur la base du second faisceau lumineux et de la lumière diffusée à partir de ladite position dans une direction, différente de celle desdits moyens de détection, en tant que résultat de la projection du premier faisceau lumineux, dans lequel lesdits moyens de traitement de signaux servent à inspecter l'état dans ladite position sur la base de signaux de battement des lumières d'interférene détectées, détectées par lesdits premiers et seconds moyens de détection.

23. Appareil selon la revendication 22, comportant en outre des moyens oscillants destinés à générer un signal à haute fréquence, d'une fréquence différente de celle du signal de battement de la lumière d'interférence détectée, et des moyens de multiplication destinés à multiplier mutuellement le signal à haute fréquence et le signal de battement, et dans lequel l'état de ladite position inspectée est déterminée sur la base du résultat de la multiplication.

24. Appareil selon la revendication 1, dans lequel lesdits moyens de détection comprennent des moyens oscillants destinés à générer un signal à haute fréquence, d'une fréquence différente de celle du signal de battement de la lumière d'interférence détectée, et des moyens de multiplication destinés à multiplier mutuellement le signal à haute fréquence et le signal de battement, lesdits moyens d'inspection inspectant l'état de ladite position sur la base du résultat de la multiplication.

25. Appareil selon la revendication 24, dans lequel lesdits moyens oscillants comprennent des moyens destinés à générer électriquement le signal à haute fréquence.

26. Appareil selon la revendication 24, dans lequel lesdits moyens oscillants comprennent des moyens destinés à générer optiquement le signal à haute fréquence.

27. Appareil d'exposition ayant un appareil d'inspection selon l'une quelconque des revendications 1 à 26.

28. Système de nettoyage et d'inspection ayant un appareil d'inspection selon l'une quelconque des revendications 1 à 26.

29. Système de fabrication de dispositifs ayant un appareil d'inspection selon l'une quelconque des revendications 1 à 26.

30. Procédé de fabrication de dispositifs comprenant les étapes d'inspection d'un motif de dispositif présenté par un masque, utilisant l'appareil d'inspection selon l'une quelconque des revendications 1 à 26, de transfert sur une pièce du motif de dispositif du masque, et de formation d'un dispositif à partir de la pièce portant le motif.

FIG. I

# FIG. 2

F I G. 3

F I G. 4

FIG. 5

EP 0 567 701 B1

F I G. 6

F I G. 7

FIG. 8

**F I G. 9**

EP 0 567 701 B1

FIG. 10A

FIG. 10B

FIG. 11

FIG. 12

F I G. 13

EP 0 567 701 B1

FIG. 14

POLARIZED LIGHT
SCATTERING
DISTRIBUTION
(PARTICLE DIAM: 0.3μm)

260P

260S

F I G. 15A

POLARIZED LIGHT
SCATTERING
DISTRIBUTION
(PARTICLE DIAM: 0.5μm)

261P

261S

F I G. 15B

POLARIZED LIGHT
SCATTERING
DISTRIBUTION
(PARTICLE DIAM: 1.0μm)

262P

262S

F I G. 15C

F I G. 16

# FIG. 17A

P(w), S(w+△w)

13

14

29

42

20

21

# FIG. 17B

CIRCUIT
PATTERN

DIRECTION
OF SCAN

LIGHT
SPOT 20

# FIG. 18

FOREIGN
PARTICL

DIRECTION
OF SCAN

CIRCUIT
PATTERN

LIGHT
SPOT 20

SUBSTRATE

# FIG. 19

DETECTED
INTENSITY

FOREIGN-
PARTICLE
SIGNAL

PATTERN-
CIRCUIT
SIGNAL

$a_g$

$a_P$

TIME

# F I G. 20

F I G. 21

EP 0 567 701 B1

(A)

VOLTAGE

TIME

(B)

VOLTAGE

TIME

(C)

VOLTAGE

TIME

# F IG. 22

# FIG. 23

# F I G. 24

EP 0 567 701 B1

```
                                    ┌──────────────┐
                                    │ SLICE LEVEL  │──822
                                    │ GENERATOR    │
                                    └──────┬───────┘
                                           │ (B)
  29          820                    821         823          824         825
┌──────────────┐  ┌──────────────┐  ┌──────────┐  ┌──────────┐  ┌──────────┐  ┌──────────┐
│              │  │              │  │          │  │          │  │ EDGE     │  │ PULSE    │
│ PHOTODETECTOR│─▶│ HIGH-PASS    │─▶│SUBTRACTING│─▶│BINARIZING│─▶│ PULSE    │─▶│ COUNTING │
│              │  │ FILTER   (A) │  │ CIRCUIT (C)│  │ CIRCUIT (D)│  │ SHAPING  │(E)│ CIRCUIT │
└──────────────┘  └──────────────┘  └──────────┘  └──────────┘  │ CIRCUIT  │  └──────────┘
                                                                 └──────────┘
```

RESET COMMAND

```
     826          828
  ┌──────────┐  ┌──────────┐
  │COMPARING │─▶│ DISCRIM. │──▶ OUTPUT
  │ CIRCUIT  │  │ CIRCUIT  │
  └──────────┘  └──────────┘

┌──────────────┐
│ COUNTING     │──827
│ THRESHOLD    │
│ GENERATOR    │
└──────────────┘
```

# FIG. 25

F I G. 26

F I G. 27

FIG. 28

F I G. 29

EP 0 567 701 B1

FIG. 30

FIG. 31

# F I G. 32